(19) Europäisches Patentamt
European Patent Office
Office européen des brevets

(11) EP 2 762 908 B1

(12) EUROPEAN PATENT SPECIFICATION

(45) Date of publication and mention
of the grant of the patent:
**19.08.2015 Bulletin 2015/34**

(51) Int Cl.:
*G01R 31/36* [(2006.01)]

(21) Application number: **14153425.5**

(22) Date of filing: **31.01.2014**

(54) **Battery cell performance estimation method and battery cell performance estimation apparatus**

Verfahren zur Schätzung der Zellleistung einer Batterie und Vorrichtung zur Schätzung der Zellleistung einer Batterie

Procédé d'estimation de performance de cellules d'accumulateur et appareil d'estimation de performance de cellules d'accumulateur

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.02.2013 JP 2013019808**

(43) Date of publication of application:
**06.08.2014 Bulletin 2014/32**

(73) Proprietor: **Kabushiki Kaisha Toshiba Tokyo 105-8001 (JP)**

(72) Inventors:
 • **Morita, Tomokazu**
 **Tokyo, 105-8001 (JP)**
 • **Hoshino, Masayuki**
 **Tokyo, 105-8001 (JP)**

(74) Representative: **Hoffmann Eitle Patent- und Rechtsanwälte PartmbB Arabellastraße 30 81925 München (DE)**

(56) References cited:
**US-A1- 2008 054 848     US-A1- 2009 096 459
US-A1- 2010 141 262     US-A1- 2011 309 838**

 • **GUERFI A ET AL: "Investigations on some electrochemical aspects of lithium-ion ionic liquid/gel polymer battery systems", JOURNAL OF SOLID STATE ELECTROCHEMISTRY ; CURRENT RESEARCH AND DEVELOPMENT IN SCIENCE AND TECHNOLOGY, SPRINGER, BERLIN, DE, vol. 13, no. 7, 17 October 2008 (2008-10-17), pages 1003-1014, XP019661211, ISSN: 1433-0768**
 • **GAO F ET AL: "Kinetic behavior of LiFePO4/C cathode material for lithium-ion batteries", ELECTROCHIMICA ACTA, ELSEVIER SCIENCE PUBLISHERS, BARKING, GB, vol. 53, no. 15, 1 June 2008 (2008-06-01), pages 5071-5075, XP022590829, ISSN: 0013-4686, DOI: 10.1016/J.ELECTACTA.2007.10.069 [retrieved on 2007-11-07]**
 • **PRADA E ET AL: "A coupled OD electrochemical ageing & electro-thermal Li-ion modeling approach for HEV/PHEV", 2011 IEEE VEHICLE POWER AND PROPULSION CONFERENCE (VPPC 2011) : CHICAGO, ILLINOIS, USA, 6 - 9 SEPTEMBER 2011, IEEE, PISCATAWAY, NJ, 6 September 2011 (2011-09-06), pages 1-8, XP031974792, DOI: 10.1109/VPPC.2011.6043002 ISBN: 978-1-61284-248-6**

EP 2 762 908 B1

**Description**

FIELD

Embodiments described herein relate generally to a cell performance estimation method and cell performance estimation apparatus for estimating the performance of a secondary cell.

BACKGROUND

Nonaqueous electrolyte secondary cells such as a lithium-ion secondary cell have high energy densities and are used as the power supplies of various portable electronic apparatuses. In addition, the practical use of these nonaqueous electrolyte secondary cells in hybrid vehicles, hybrid motorcycles, electric vehicles, and electric motorcycles is recently being examined. It is assumed that secondary cells for use in these vehicles and the like are used for an operation period of 10 to 15 years like that of the vehicles themselves. Also, at the end of the lifetime, a cell cannot be in an unfunctional state, but must have a minimum necessary performance capable of moving a vehicle. That is, a secondary cell must hold a capacity and be able to output a minimum necessary energy even at the end of the lifetime.

When using a vehicle secondary cell, therefore, it is indispensable to diagnose the degree of deterioration of the cell and predict the performance over a long use period exceeding 10 years. In addition, the diagnosis of deterioration desirably requires neither a long time nor a special equipment or installation, from the viewpoints of user's convenience and expenses. As a method of meeting these requirements, estimating the degree of deterioration by calculations from the charging/discharging curve (voltage vs. time/current data) of a cell is being examined. As one of these methods, a method of estimating the capacity and internal resistance of a cell and the degree of deterioration of each active material of the cathode and anode by referring to the open circuit potential-charged amount data of the active material, from a charging/discharging curve (cell voltage-time data) obtained when the cell is actually charged/discharged under predetermined conditions is disclosed (JP-A 2012-251806(KOKAI)).

US 2011/309838 A1 describes a system and method for estimating internal parameters of a lithium-ion battery to provide a reliable battery state-of-charge estimate by using a two RC-pair equivalent battery circuit model.

US 2008/054848 A1 teaches a battery management system that estimates an internal impedance of a battery, a method of driving the same, a device that estimates an internal impedance of a battery, and a method of estimating the internal impedance of a battery.

US 2009/096459 A1 shows a measuring method of a battery including the step of measuring frequency characteristics of an internal impedance of the battery by an AC impedance method, and determining a parameter of an element representing ease of mobility of charges on a surface of a positive electrode of the battery and that of an element representing the ease of mobility of charges on the surface of a negative electrode.

US 2010/141262 A1 discloses that a method utilising the resistance of the electrolytic membrane of a fuel cell is known conventionally as a method for detecting abnormality occurring in the fuel cell.

GUERFI A ET AL: "Investigations on some electrochemical aspects of lithium-ion ionic liquid/gel polymer battery systems", JOURNAL OF SOLID STATE ELECTROCHEMISTRY ; CURRENT RESEARCH AND DEVELOPMENT IN SCIENCE AND TECHNOLOGY, SPRINGER, BERLIN, DE, vol. 13, no. 7, 17 October 2008, pages 1003-1014, XP019661211, shows the investigation of electrochemical and interfacial characteristics of a Li-ion battery system based on $LiFePO_4$ cathode and graphite anode with ionic liquid electrolytes, both with and without addition of a small amount of polymer to the electrolyte.

GAO F ET AL: "Kinetic behavior of LiFePO4/C cathode material for lithium-ion batteries", ELECTROCHIMICA ACTA, ELSEVIER SCIENCE PUBLISHERS, BARKING, GB, vol. 53, no. 15, 1 June 2008, pages 5071-5075, XP022590829, describes the kinetic behavior of $LiFePO_4$/C cathode material for lithium-ion batteries.

Further, PRADA E ET AL: "A coupled OD electrochemical ageing & electro-thermal Li-ion modeling approach for HEV/PHEV", 2011 IEEE VEHICLE POWER AND PROPULSION CONFERENCE (VPPC 2011) : CHICAGO, ILLINOIS, USA, 6 - 9 SEPTEMBER 2011, IEEE, PISCATAWAY, NJ, 6 September 2011, pages 1-8, XP031974792, describes an electrochemical ageing / electro-thermal Li-ion model for hybrid-electric vehicles and plug-in hybrid electric vehicles.

Unfortunately, the operation temperature of a cell mounted in a vehicle or of a stationary type cell generally fluctuates due to, e.g., the external environment and operation conditions. In the method disclosed in the above-mentioned literature, if the cell temperature changes by 10°C or more, the performance of the cell, particularly, the internal resistance value of the cell largely changes in accordance with the temperature. This makes it difficult to perform deterioration diagnosis by the cell characteristics estimated from the charging/discharging curve. Also, the dependence of the internal resistance of a cell on the temperature changes due to deterioration. Therefore, cell performance diagnosis requires a method capable of correcting the internal resistance of a cell in accordance with the temperature over the whole performance deterioration process.

BRIEF DESCRIPTION OF THE VIEWS OF THE DRAWING

FIG. 1 is a view showing an outline of each resistance component of the internal resistance of a cell;
FIG. 2 is a block diagram showing the functional configuration of a cell performance estimation system according to an embodiment;
FIG. 3 is a view showing charge curves and open circuit voltages;
FIG. 4 is a view showing an example of an electromotive force as a function of the charged capacity of a cathode using active materials A and B;
FIG. 5 is a view showing an example of a potential as a function of the charged capacity of the cathode;
FIG. 6 is a view showing an example of the change in anode potential, which is caused by an increase in current value, as a function of a charged capacity;
FIG. 7A is a view showing plots of the open circuit potential-charged capacity of lithium cobalt oxide;
FIG. 7B is a view showing plots of the open circuit potential-charged capacity of lithium titanate;
FIG. 8A is a view showing entropy-charged capacity plots derived from the measurements of the change in open circuit potential with the temperature;
FIG. 8B is a view showing entropy-charged capacity plots derived from the measurements of the change in open circuit potential with the temperature;
FIG. 9 is a view showing the change in open circuit potential curve of lithium cobalt oxide with the temperature;
FIG. 10A is a view showing the fine tuning of physical parameters using nonlinear optimization;
FIG. 10B is a view showing a plot of the diffusion resistance component of lithium cobalt oxide as a function of the charged capacity;
FIG. 11A is a view showing a plot of the reaction resistance component of lithium titanate as a function of the charged capacity;
FIG. 11B is a view showing a plot of the diffusion resistance component of lithium titanate as a function of the charged capacity;
FIG. 12A is a view showing the results of AC impedance measurements performed on a cell using lithium cobalt oxide as a cathode and lithium titanate as an anode;
FIG. 12B is a view showing an Arrhenius plot of the reaction resistance component;
FIG. 13 is a view showing the deterioration states of cells at different temperatures in a storage test;
FIGS. 14A, 14B, 14C, and 14D show plots of the reaction resistance component at different temperatures for cells;
FIG. 15 is a view showing the values of Ea and A obtained for measurement values at each SOC of cells 1 to 4;
FIG. 16A, 16B, 16C, and 16D show plots of the ohmic resistance component at different temperatures for cells;
FIG. 17 is a view showing a plot of the ohmic resistance as a function of the cell temperature;
FIG. 18A is a view showing the results of calculations of Ec and A of cells 1 to 4;
FIG. 18B is a view showing the results of calculations of R1 of cells 1 to 4;
FIG. 19A is a view showing the results of measurements when a charging current pulse is applied to a cell using lithium cobalt oxide as a cathode and lithium titanate as an anode;
FIG. 19B is a view showing values obtained by dividing overvoltage components shown in FIG. 19A by the current value;
FIG. 20A is a view showing plots of the diffusion resistance component of cell 1 (storage temperature = 25°C) measured by changing the charged capacity and temperature;
FIG. 20B is a view showing plots of the diffusion resistance component of cell 2 (storage temperature = 55°C) measured by changing the charged capacity and temperature;
FIG. 21 is a view showing the values of Eb obtained for cells 1 and 2;
FIG. 22 is a view showing results when the change in cell internal resistance with the temperature is plotted by using calculated Ea, Eb, and Ec;
FIG. 23 is a view showing charge curves and plots of the cell surface temperature when cell 1 is charged at 0°C, 5°C, 10°C, 25°C, and 45°C;
FIG. 24 is a view showing results when Rct, Rd, and Rohm are calculated for the charge curve at each temperature shown in FIG. 23; and
FIG. 25 is a view showing results when the internal resistance value calculated at each temperature is corrected to a reference temperature (25°C) based on the results shown in FIG. 23.

DETAILED DESCRIPTION

In general, according to one aspect, a cell performance estimation method includes the features of independent claim 1. According to another aspect, a cell performance estimation apparatus includes the features of independent claim 8. Preferred embodiments are outlined in the respective dependent claims.

A cell performance estimation method and cell performance estimation apparatus according to the embodiment will be explained in detail below with reference to the accompanying drawing.

[Principle and Method]

The cell performance estimation method according to the embodiment provides a means for correcting the influence of a temperature to a cell performance diagnosis method of estimating the capacity and internal resistance of a cell and the degree of deterioration of each active material of the cathode and anode by referring to the open circuit potential-charged capacity data of the active material from a charging/discharging curve, thereby widening a favorably applicable temperature range. The principle and method are as follows.

(Analysis of Charging/discharging curve)

A lithium-ion secondary cell includes a cathode and anode opposing each other and an electrolyte containing Li salt between the cathode and anode. In the cathode and anode, collector foils are coated with active materials, and connected to the cathode and anode terminals of a cell jacket. When charging/discharging the cell, Li ions move between the cathode active material and anode active material through the electrolyte, and electrons flow from the active materials to an external terminal.

Each active material has an Li amount and potential that can reversibly be inserted and desorbed. An energy amount that can be stored in a cell within a predetermined charge/discharge voltage range is determined by the amounts of cathode active material and anode active material in the cell and a combination of the materials.

Also, at the time of charge/discharge, Li ion conduction occurs, a charge transfer resistance is generated when Li ions in the electrolyte enter the active material, a resistance is generated by a film formed in the interface between the electrolyte and active material, and an electrical resistance is generated when electrons flow through the active material and collector foil. The internal resistance of the cell is the sum total of the Li ion movement, the electron movement, the charge transfer resistance, the resistance generated by the film, and the diffusion resistances in the cathode and anode.

In a cell control system of a lithium-ion secondary cell, the voltage of the cell and the internal temperature of a cell pack are generally measured from the viewpoint of safety. If the cell performance can be calculated by using these data, therefore, deterioration diagnosis can be performed without spending the cost and time.

Unfortunately, when analyzing a cell behavior in actual use in which the charge/discharge conditions finely change at random, a resistance depending on the time, a diffusion resistance, a relaxation process, and the like are complicatedly combined, so the formation of a calculation model of the phenomenon is not easy. On the other hand, when a simple behavior such as an electric vehicle charge curve obtained under predetermined conditions is a target, analysis can be performed by a simplified model.

In the cell performance estimation method according to this embodiment, therefore, a charge or discharge curve obtained under predetermined conditions is used, and the values of variables, i.e., the amount of each active material, and the rise (overvoltage) of the cell voltage caused by the internal resistance when a charge current is applied, are determined by fitting calculations based on a potential-charged capacity curve with respect to the Li insertion/desorption reaction of the active material. This makes it possible to estimate the reduction in capacity (the reduction of each active material), and the increase in internal resistance.

When a cell is actually used, the temperature condition changes in accordance with the external environment and the state of the cell when it is charged. When the temperature of the cell changes, the cell performance also changes, and particularly the internal resistance largely increases as the temperature decreases. Therefore, even when comparing analytical results from measurement data obtained at different temperatures, the variations in analytical results caused by the temperature have a large influence, and this makes it difficult to evaluate the increase in internal resistance caused by deterioration.

Accordingly, temperature correction of the internal resistance is necessary to estimate the cell characteristics and evaluate the progress of deterioration from measurement data of the cell in actual use. The internal resistance of a cell is obtained by combining various resistance components as described previously, and these components are different in temperature dependence and increase rate resulting from deterioration. When deterioration progresses, therefore, the ratio occupied by the resistance changes, and the temperature dependence of the whole internal resistance changes accordingly. By noting this fact, in the temperature correction of the internal resistance performed by the cell performance estimation method of this embodiment, the internal resistance is divided into three components, i.e., a reaction resistance, ohmic resistance, and diffusion resistance, each resistance is corrected to a reference temperature To in accordance with the temperature dependence unique to the resistance, and the results are added up.

More specifically, the cell temperature at the time of measurement is corrected to the reference temperature by equations to be described below. Note that in these equations, R is a gas constant, $T_0$ is the reference temperature, and T is the cell temperature at the time of measurement:

Reaction resistance

$$Rct(T_0) = Rct(T) \times Exp(-Ea/(R \cdot T))/Exp(-Ea/(R \cdot T_0))$$

Diffusion resistance

$$Rd(T_0) = Rd(T) \times Exp(-Eb/(R \cdot T))/Exp(-Eb/(R \cdot T_0))$$

Ohmic resistance

$$Rohm(T_0) = (Rohm(T) - R1) \times Exp(-Ec/(R \cdot T))/Exp(-Ec/(R \cdot T_0)) + R1$$

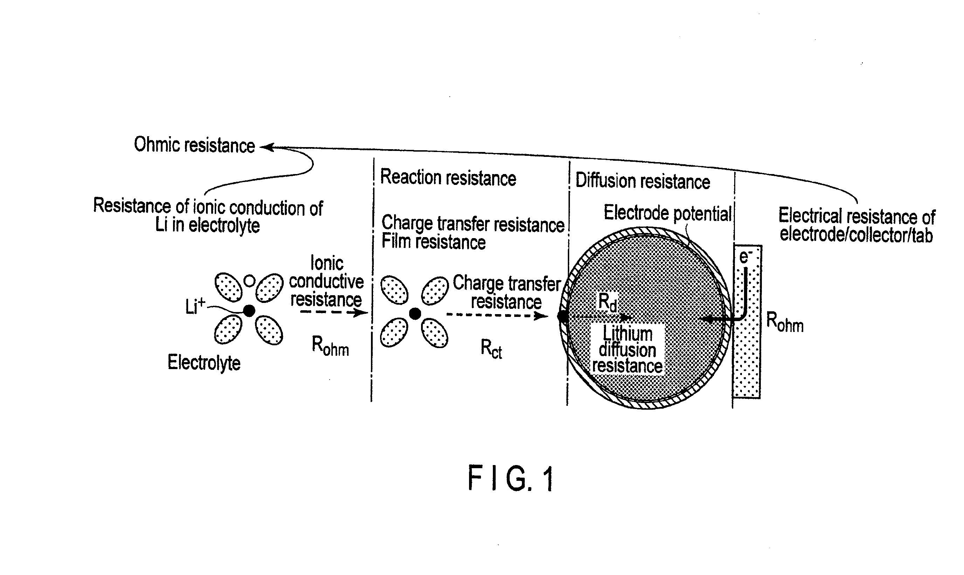

FIG. 1 shows an outline of each resistance component. The reaction resistance contains the charge transfer resistance and the resistance of a surface film. The ohmic resistance contains the ion conduction resistance of an electrolyte and an electron conduction resistance in the cell, and the electron conduction resistance having a relatively small temperature dependence is a constant. The diffusion resistance contains a resistance resulting from lithium ion diffusion in the active materials and electrodes.

Constants for determining the dependence of each resistance component on the temperature are Ea, Eb, and Ec in the above equations. The meanings of these constants are as follows. Ec of the ohmic resistance is activation energy when Li ions move in the electrolyte. Ea of the reaction resistance is energy when Li ions solvated in the electrolyte are desolvated on the active material surface. Eb of the diffusion resistance is activation energy caused by movement between Li ion sites inside the active material. Accordingly, these values are presumably constant and unchanging in the deterioration process.

The values of Ea, Eb, and Ec can be calculated by, e.g., the AC impedance measurement or current pulse measurement of a single cell. The values of Ea, Eb, and Ec calculated beforehand from measurement values of a cell to be analyzed are stored in a database, and quoted when estimating the temperature correction of the internal resistance.

Next, a method of separately calculating the cell characteristics from charging/discharging curves for the three components of the internal resistance will be explained.

In a cell deterioration process, all the three components of the internal resistance rise, but the rate of increase caused by deterioration changes from one component to another. An assumption that no deterioration occurs sometimes holds by limiting the range of the lifetime to be evaluated. Assuming that a cell of an electric vehicle is an evaluation target and the lower limit of the evaluation is a residual capacity of about 90% to 70%, a given resistance component can be approximated to a predetermined value throughout the cell lifetime in some cases, depending on the use conditions and cell configuration.

Of the three components of the internal resistance defined in this embodiment, the reaction resistance has the largest temperature dependence and largest deterioration. The reaction resistance increases due to a side reaction in the interface between the electrolyte and active material surface and a change in quality of the active material surface. Even when the cell is in a state of rest, deterioration progresses due to the potential difference between the electrolyte and active material. Generally, the reaction resistance often increases in proportion to the square root of time.

By contrast, the deterioration behaviors of the diffusion resistance and ohmic resistance change in accordance with the configurations of, e.g., the active material of the cell and the electrolyte, and the use conditions. The diffusion resistance component and ohmic resistance comment increase probably because the electrolyte distribution state in the electrode accommodated in the cell changes, the electrolyte runs out on a portion of the electrode, the quality of the electrolyte changes, and the structure of an active material layer formed on the collector of the electrode becomes loose due to a volume change of the active material caused by charge/discharge. The manufacturing accuracy of the cell such as a variation in electrode coating amount of the cell or the distribution state of the electrolyte in the cell is also an important factor. Deterioration can be decreased depending on the type of active material or the cell use conditions, and the deterioration of the diffusion resistance and ohmic resistance can be ignored in some cases within the range of the lifetime of, e.g., a vehicle cell. In accordance with this, the method of estimating each component of the internal resistance can be changed.

(First Method)

The first method is a method of calculating the three components from the calculated internal resistance value of the cell by assuming that the ohmic resistance component and diffusion resistance component are constant, and using the residual as the reaction resistance. In this method, only a temperature change depending on the cell temperature is taken into consideration by assuming that the ohmic resistance component and diffusion resistance component do not increase by deterioration. When analyzing a charging/discharging curve, the ohmic resistance component and diffusion resistance component at a measurement temperature T are subtracted from the internal resistance value estimated for a given temperature T, and the residual is used as the reaction resistance component. The individual components are corrected to the reference temperature To and summed up, and the sum is corrected as an internal resistance value at the reference temperature $T_0$. The first method is suited when the cell is used easy with a relatively small electric current at a temperature close to or below room temperature within the SOC range in which the active materials of the cathode and anode are stable.

(Second Method)

The second method is a method of estimating the ohmic resistance component and diffusion resistance component by a function of the accumulated time or accumulated power amount, and using the residual as the reaction resistance. In this method, the ohmic resistance component and diffusion resistance component are calculated by assuming that that the deterioration of the ohmic resistance component and diffusion resistance component correlate with the time or charge/discharge cycle amount. When analyzing a charging/discharging curve, correction values are subtracted from the internal resistance value estimated at a given temperature T to the measurement temperature T of the above-described calculated ohmic resistance component and diffusion resistance component, and the residual is used as the reaction resistance component. The individual components are corrected to the reference temperature To and summed up, thereby calculating the internal resistance value at the reference temperature $T_0$. The second method is suited when the deterioration of the ohmic resistance component and diffusion resistance component is relatively small but definitely progresses. When deterioration progresses during storage by, e.g., the generation of a gas, deterioration amount estimation by the accumulated time is suitable. When deterioration by the repetition of cycles caused by the volume change of the active material is significant, deterioration amount estimation by the accumulated power amount is suitable. It is necessary to hold data of the accumulated time or accumulated power amount, and the accumulated power amount may also be substituted with the operation amount of an apparatus, e.g., the mileage of a vehicle.

(Third Method)

The third method is a method of estimating the reaction resistance component and diffusion resistance component by previously held diffusion resistance-charged capacity data and reaction resistance-charged capacity data of each active material, and using the residual as the ohmic resistance component. Unlike the first and second methods, the third method is a method by which, when analyzing a charging/discharging curve, the values of the reaction resistance and diffusion resistance are estimated by regression calculations by referring the reaction resistance-charged capacity curve and diffusion resistance-charged capacity curve of the active material and the internal resistance-charged capacity curve of the cell. The resistance component of the active material has dependence on the charged capacity, i.e., SOC, and the tendency of this dependence does not change by deterioration. By using these properties, the component of the internal resistance is estimated from the tendency of the internal resistance-charged capacity of the cell. The reaction resistance-charged capacity curve and diffusion resistance-charged capacity curve of the active material must be measured in advance. It is also necessary to measure the manner of change by deterioration because it depends on the configuration of the cell. For example, when a resistive surface film is formed, the resistance presumably evenly increases by a predetermined amount. When the active material reduces, the resistance probably evenly becomes n times.

The third method is suited when the reaction resistance-charged capacity significantly changes and as a consequence the reaction resistance as a cell has a clear dependence on the charged capacity.

(Fourth Method)

The fourth method is a method of estimating the reaction resistance component, ohmic resistance component, and diffusion resistance component by regression calculations by using previously held diffusion resistance-charged capacity data, reaction resistance-charged capacity data, and ohmic resistance-charged capacity data of each active material. Although the third method uses only the diffusion resistance-charged capacity and reaction resistance-charged capacity, the feature of the fourth embodiment is to use the ohmic resistance-charged capacity data as well. The fourth method is effective when the dependence on the ohmic resistance-charged capacity of the active material has a special feature, e.g., the electron conductivity of the active material largely changes due to charge/discharge.

[Configuration]

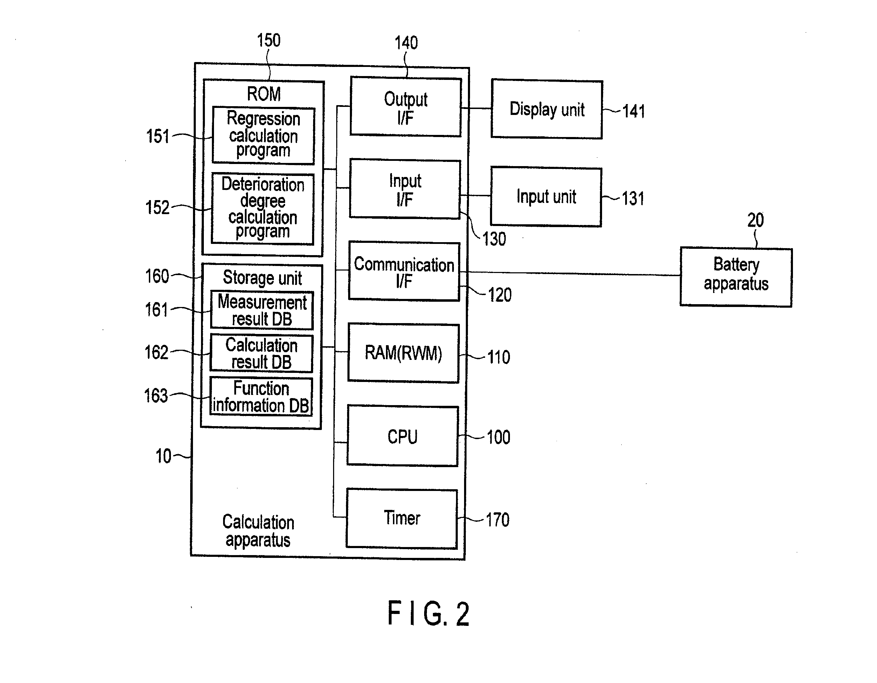

FIG. 2 is a block diagram showing the functional configuration of the cell performance estimation system according to this embodiment.

The cell performance estimation system shown in FIG. 2 is a computer system for calculating the residual capacity of a battery apparatus 20 including one or a plurality of secondary cells and the like. In this embodiment, a calculation apparatus (cell performance estimation apparatus) 10 as one constituent element of the cell performance estimation system can be configured by calculation devices combined across a communication network such as a LAN or intranet in accordance with the processing function.

The calculation apparatus 10 includes a CPU 100, RAM (RWM) 110, communication I/F 120, input I/F 130, output I/F 140, ROM 150, storage unit 160, and timer 170. The calculation apparatus 10 can also include an I/F (interface) for attaching an external memory such as a USB memory. The calculation apparatus 10 is a computer for performing arithmetic operations by executing programs.

The calculation apparatus 10 collects data such as a current value and voltage value from the battery apparatus 20 via the communication I/F 120, and performs various calculation processes by using the collected data.

The CPU 100 is an arithmetic processing unit (microprocessor) that reads out each program prewritten in the ROM 150 to the RAM 110, and performs a calculation process. The CPU 100 can be configured by a plurality of CPUs (microcomputers and microcontrollers) in accordance with functions. The CPU 100 may also include an internal memory having a RAM function.

The RAM (RWM) 110 is a storage area to be used when the CPU 100 executes a program, and is a memory to be used as a working area. The RAM 110 is suited to temporarily store data necessary for processing.

The communication I/F 120 is a communication device or communicating means that exchanges data with the secondary battery apparatus. An example is a router. In this embodiment, the communication I/F 120 and battery apparatus 20 are connected by wired communication. However, this wired connection may also be replaced with any of various wireless communication networks. In addition, the communication I/F 120 and battery apparatus 20 may also be connected across a network capable of one-way or two-way communication.

The input I/F 130 is an interface for connecting the input unit 131 and calculation apparatus 10. The input I/F 130 may also have an input control function of converting an input signal supplied from the input unit 131 into a signal recognizable by the CPU 100. This I/F is not an essential constituent element such as a terminal, and may also be directly connected to an internal wiring line in the calculation apparatus.

The input unit 131 is an input device or input means for performing input control of, e.g., various keyboards and buttons generally included in a computer apparatus. The input unit 131 may also have a function of recognizing or detecting a human voice as an input signal. Although the input unit 131 is installed outside the calculation apparatus 10 in this embodiment, the input unit 131 may also be incorporated into the calculation apparatus.

The output I/F 140 is an interface for connecting the display unit 141 and calculation apparatus 10. Display control of the display unit 141 can be performed by the CPU 100 via the output I/F 140, and can also be performed by an LSI (GPU) for performing a drawing process such as a graphic board. An example of the display control function is a decoding function of decoding image data. It is also possible to directly connect the display unit 141 to the interior of the calculation apparatus 10 without using any I/F.

The display unit 141 is an output device or output means such as a liquid crystal display, organic EL display, or plasma display. The display unit 141 may also have a function of generating a sound. The display unit 141 is installed outside the calculation apparatus 10 in this embodiment, but the display unit 141 may also be incorporated into the calculation apparatus 10.

The ROM 150 is a program memory storing a regression calculation program 151 and deterioration degree calculation program 152. It is favorable to use a non-transitory storage medium to which no data is written, but a storage medium such as a semiconductor memory to which data can be written can also be used. The ROM 150 may also store, e.g., a display program for causing the display unit 141 to display image data as characters and figures recognizable by humans, a program for distributing contents such as cell deterioration information to a terminal 30 via the communication I/F 120, and an information registration program for causing the storage unit 160 to store acquired data for every predetermined time.

Measured cell voltage, electric current, and temperature-time data can be stored in a measurement result DB 161. A function information DB 163 stores a function representing the relationship between a charged capacity and a cathode open circuit potential, each resistance component, and entropy, and a function and value representing the relationship between an anode open circuit potential and a charged capacity, each resistance component, and entropy. This function information is also used to evaluate the deterioration degrees of the cathode and anode. A calculation result DB 162 stores a value calculated by the CPU 100 that executes the regression calculation program 151. The stored value can be read out by the CPU 100 and displayed on the display unit 141 via the display I/F 140. Data may also be stored in an external storage medium of the calculation apparatus 10 in a cloud computing system.

The regression calculation program 151 is a means for allowing the CPU 100 to implement a function of calculating the capacity values and internal resistance values of the cathode and anode of each battery cell or an assembled battery forming the battery apparatus 20. For example, the regression calculation program 151 calculates (analyzes) the following seven values: (1) the capacity of active material A forming the cathode; (2) the capacity of active material B forming the cathode; (3) the capacity of the anode; (4) the charged capacity of active material A forming the cathode; (5) the charged capacity of active material B forming the cathode; (6) the charged capacity of the anode; and (7) the internal resistance value.

Rohm, Rct, and Rd are calculated in a regression calculation or in an external calculation with respect to the internal resistance calculated by the regression calculation. The above-described first and second methods have the feature that Rct is calculated based on the values of Rohm and Rd calculated outside with respect to the condition such as the cell temperature from the internal resistance calculated in the regression calculation. On the other hand, the third and fourth methods have the feature that the ratios of the resistance components in the internal resistance are calculated by a regression calculation that compares the relationship between the charged capacity and Rct and Rd of each active material of the cathode and anode with the relationship between the resistance value and charged capacity of the cell.

In the third method, the dependence of the reaction resistance and diffusion resistance of each active material on the charged capacity is stored in the database, and the ratios of the reaction resistance and diffusion resistance are determined in regression calculations such that the internal resistance-charged capacity dependence of the cell matches the tendency of (the sum total of resistance components of the active material)-charged capacity. The ohmic resistance is calculated by subtracting the reaction resistance and diffusion resistance from the internal resistance value of the cell.

In the fourth method, the charged capacity dependence of the ohmic resistance is added to the regression calculation of the internal resistance-charged capacity dependence of the cell in the third method. Accordingly, the ratios of the reaction resistance, diffusion resistance, and ohmic resistance are determined by arithmetic operations such that the internal resistance-charged capacity dependence of the cell matches (the sum total of resistance components of the active material)-charged capacity tendency.

The reaction resistance Rct(T), diffusion resistance Rd(T), and ohmic resistance Rohm(T) calculated for the measurement temperature T of the cell are corrected to the reference temperature To by using the above-described equations, thereby calculating the reaction resistance Rct(T), diffusion resistance Rd, and ohmic resistance Rohm(T). Although the reference temperature is generally 25°C, an arbitrary temperature can be selected in accordance with the use environment of the cell.

The progress of deterioration to the time of measurement can be evaluated by comparing the resistance components converted into the reference temperature To and their total value with the initial and previous measurement values: $Q_{cA}, Q_{cB}, Q_{\dot{a}}, q_0^{cA}, q_0^{cB}, q_0^{a}, R$

By using these values, the change characteristic of the charging voltage with respect to time and the potential characteristic of the cathode with respect to the charged capacity and/or the potential characteristic of the anode with respect to the charged capacity are calculated. A practical operation will be described later.

The regression calculation program 151 is formed by programs corresponding to the following equations. Note that the order of the programs can be changed.

A charging voltage $V_c$ is obtained from equation (11) below by using an electromotive voltage $V_e$ of the cell and a voltage $V_R$ resulting from the internal resistance:

$$V_c = V_e + V_R \quad (11)$$

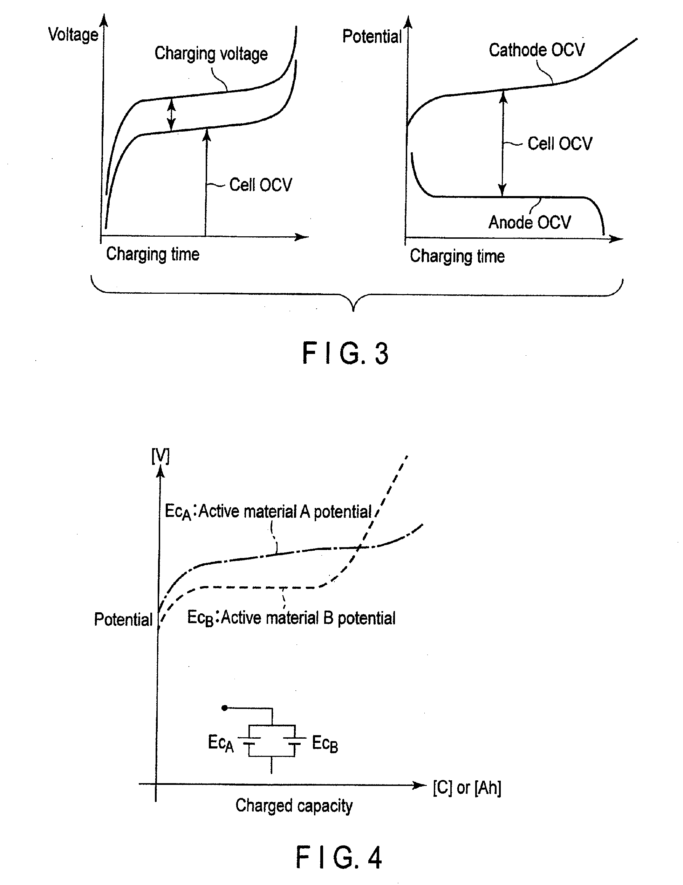

FIG. 3 shows the relationship between equations (11) and (12). In the left view of FIG. 3, the electromotive force $V_e$ is expressed as Cell OCV (Open Circuit Voltage), and the charging voltage $V_c$ is expressed as Charging voltage. Also, the potential in equation (12) represents an open circuit potential. In the right view of FIG. 3, Cathode OCV indicates a cathode potential $E_c$, and Anode OCV indicates an anode potential $E_a$.

The electromotive voltage $V_c$ of the cell is obtained from equation (12) below by using the cathode potential $E_c$ and anode potential $E_a$:

$$V_e = E_c - E_a \quad (12)$$

The potentials of the cathode and anode are obtained from equations (13) and (14) by using the charged capacity (q), a cathode capacity $Q_{ic}$ in the initial state, and an anode capacity $Q_{ia}$ in the initial state:

$$E_c = f_c(q/Q_{ic}) \quad (13)$$

$$E_a = f_a(q/Q_{ia}) \quad (14)$$

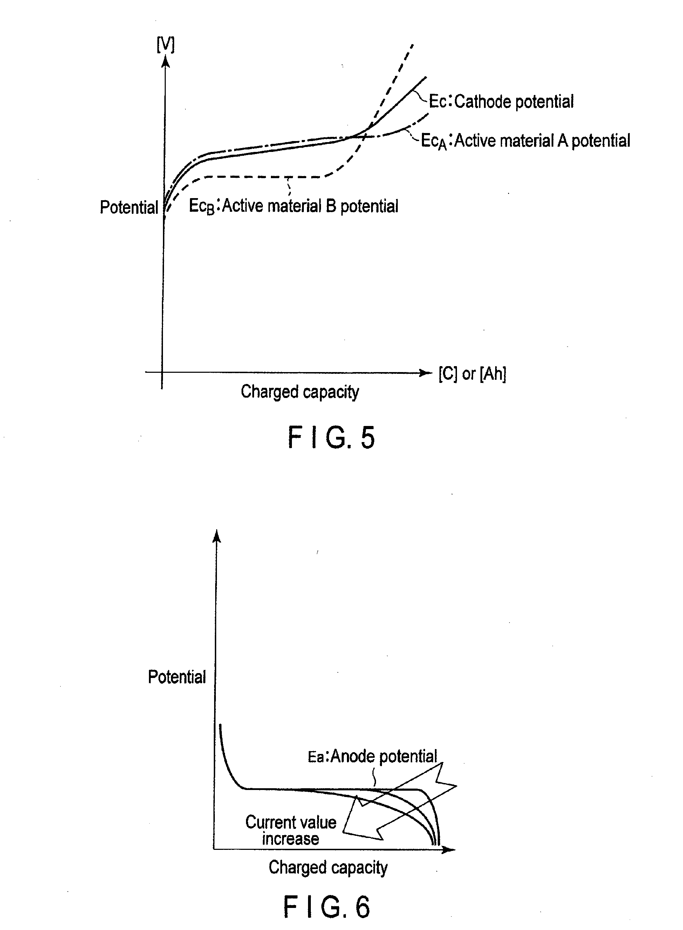

A cell in which the cathode or anode is formed by a plurality of active materials will be explained below. In this case, as shown in FIG. 4, the electromotive forces of these active materials show different characteristics. The characteristics, with respect to the charged capacity, of the electromotive voltage of a composite cathode formed by mixing active material A (e.g., lithium manganate) and active material B (e.g., lithium cobalt oxide) are calculated. FIG. 5 shows the calculated characteristics.

A cathode potential $E_{cA}$ of active material A and a cathode potential $E_{cB}$ of active material B have relationships of equations (15), (16), (17), and (18) when using a capacity $Q_{icA}$ of active material A in the initial state, a capacity $Q_{icB}$ of active material B in the initial state, a charged capacity $q_A$ of active material A, and a charged capacity $q_B$ of active material B (FIG. 5):

$$E_{cA} = f_{cA}(q_A/Q_{icA}) \quad (15)$$

$$E_{cB} = f_{cB}(q_B/Q_{icB}) \quad (16)$$

$$f_{cA}(q_A/Q_{cA}) = f_{cB}(q_B/Q_{cB}) \quad (17)$$

$$q = q_A + q_B \quad (18)$$

Accordingly, the potential $E_c$ of the composite cathode is obtained from equation (19) by using the charged capacity $q_A$ of active material A at the start of charging of the cathode and the cathode charged capacity $Q_{cA}$ of active material A, or the capacity $q_B$ of active material B at the start of charging of the cathode and the cathode charged capacity $Q_{cB}$ of active material B:

$$E_c = f_c(q/Q_{ic}) = f_{cA}(q_A/Q_{cA}) = f_{cB}(q_B/Q_{cB}) \quad (19)$$

Note that the cathode potential $E_{cA}$ of active material A and the charged capacity $q_B$ of active material B are the potentials on the surfaces of the active materials. Therefore, the diffusion resistance of lithium ions in the active material changes the lithium ion distribution in the active material, so the charging current presumably changes the relationship between the charged capacity and electromotive voltage. In this embodiment, however, the diffusion resistance is low in the active material used in the cathode and in the carbon-based active material used in the anode. It is, therefore, assumed that the relationship between the charging current and electromotive voltage does not largely change even when the charging current changes.

On the other hand, when a material having a high diffusion resistance such as lithium titanate is used as the active material of the anode, the relationship between the charged capacity and electromotive voltage largely changes due to the current value as shown in FIG. 6, so approximation similar to that of the cathode is not performed.

Accordingly, the anode potential $E_a$ is represented by:

$$E_a = f_a(q/Q_{ia}, I/Q_{ia}) \quad (20)$$

Also, the voltage $V_R$ resulting from the internal resistance is obtained by equations (21) and (22) by using a charging current I and the internal resistance R(q):

$$V_R = R(q) \times I \qquad (21)$$

$$q = \int I dt \qquad (22)$$

That is, equation (11) is represented by:

$$V_c = f_c(q/Q_{ic}) - f_a(q/Q_{ia}, I/Q_{ia}) + R(q) \times I \qquad (11A)$$

As described above, the charging voltage and the electromotive voltage characteristic and internal resistance of the active material have a nonlinear correlation. Therefore, a regression calculation is performed on the characteristic curve of the charging voltage with respect to the charged capacity by using the capacity and internal resistance of the active material as variables, thereby calculating and determining the capacity and internal resistance of the active material.

The deterioration degree calculation program 152 is a means for causing the CPU 100 to implement a function of calculating the deterioration degree of the battery apparatus 20 from the capacity and internal resistance value of the active material obtained by executing the regression calculation program 151.

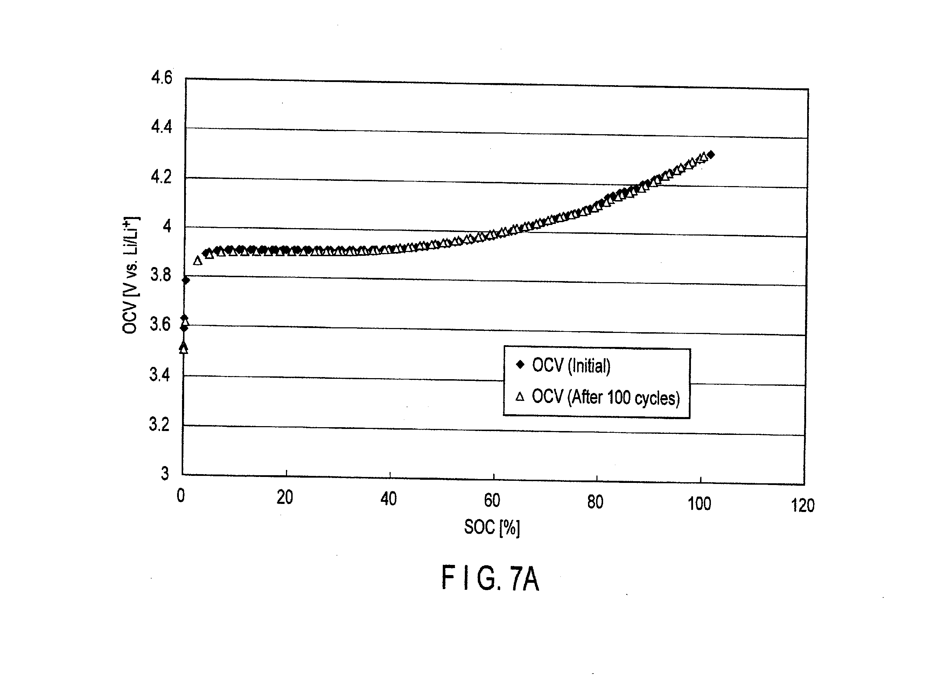

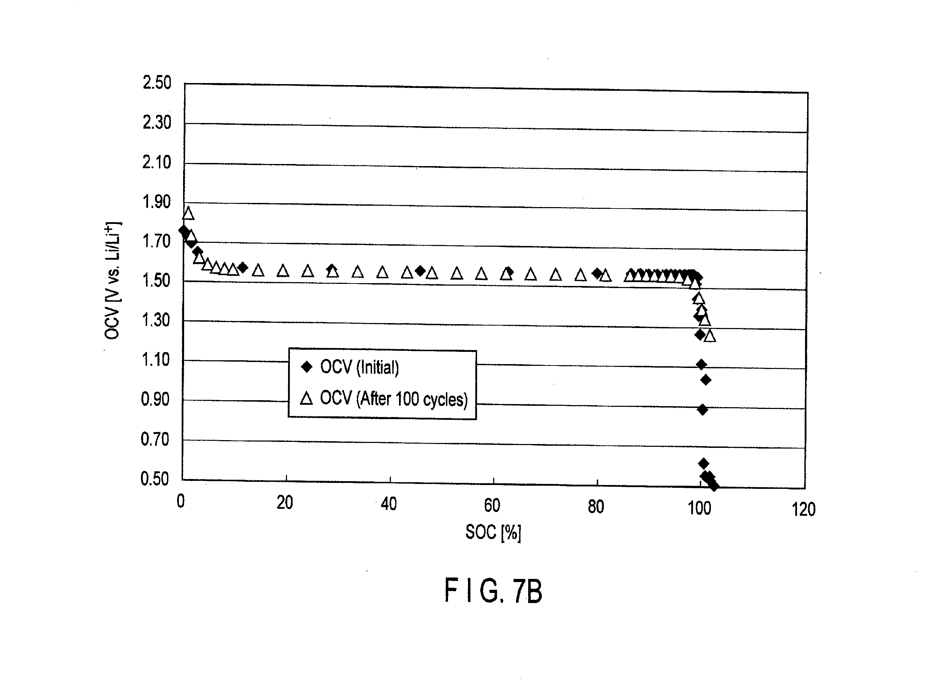

A cell in which the cathode is lithium cobalt oxide and the anode is lithium titanate will be explained as an example. FIGS. 7A and 7B show plots of the open circuit potential-charged capacity of lithium cobalt oxide and lithium titanate.

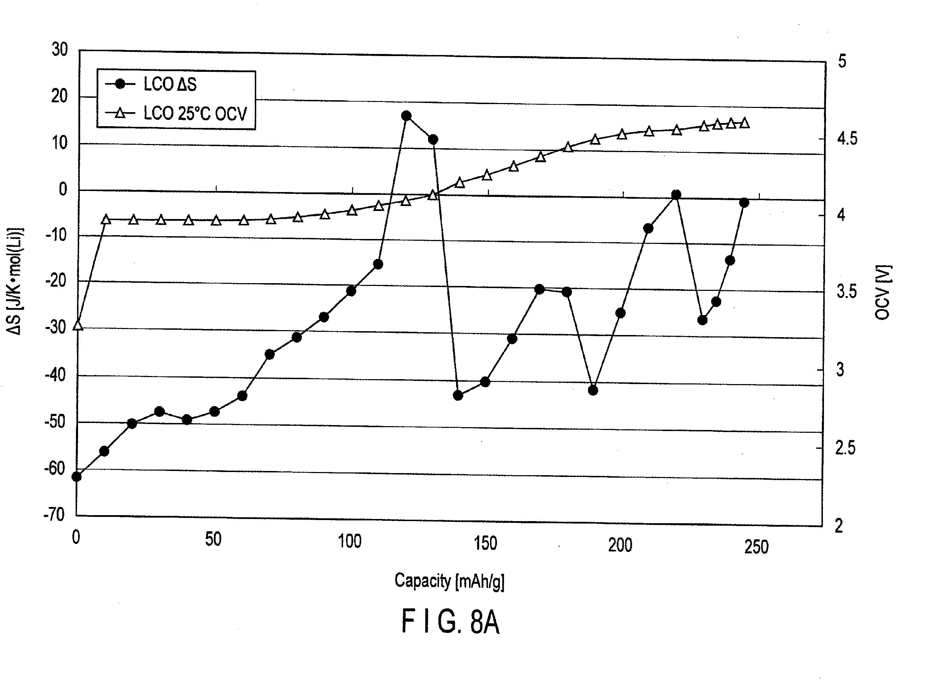

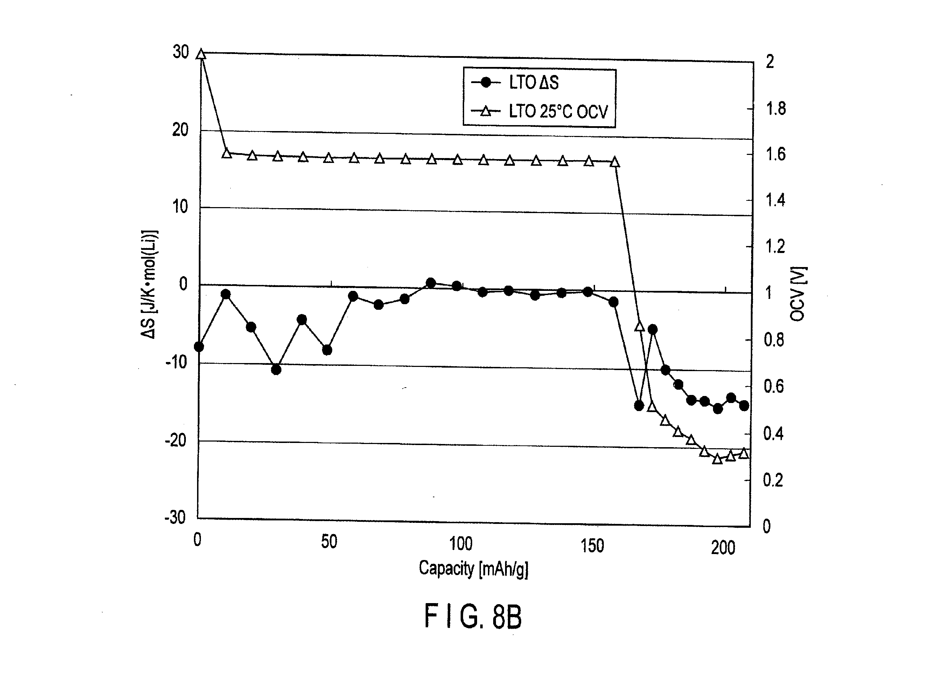

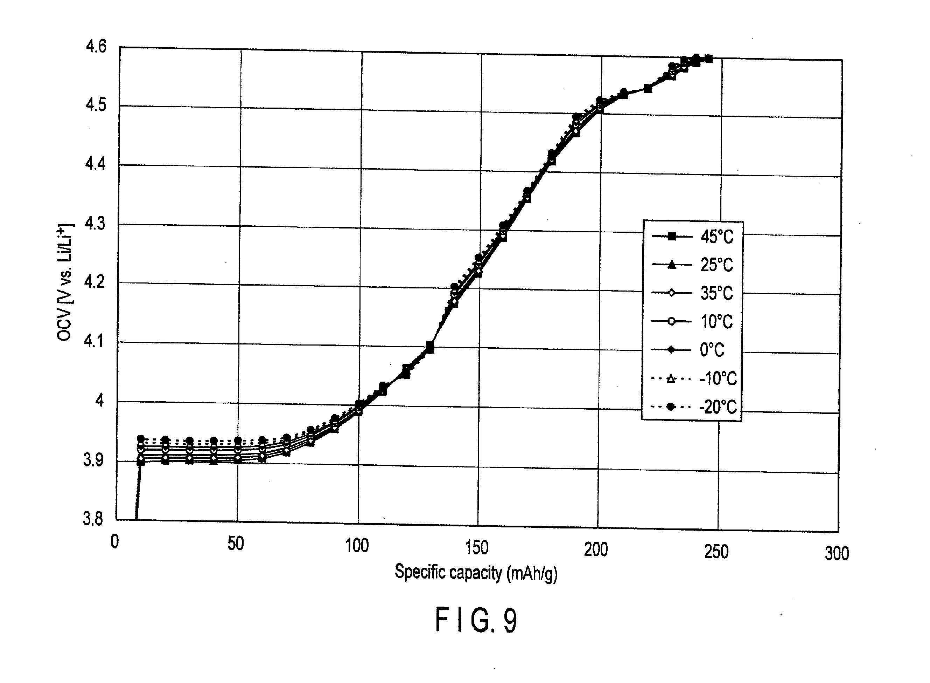

Next, correction of the temperature dependence of the open circuit voltage will be explained. FIGS. 8A and 8B show entropy-charged capacity plots derived from measurements of the change in open circuit potential with the temperature. When using lithium titanate, the charged capacity is almost 0 from charged capacity 0 to full charging, so the change in open circuit voltage with the temperature is negligible. On the other hand, the entropy value shows a relatively large change when using lithium cobalt oxide. FIG. 9 shows the change in open circuit potential curve of lithium cobalt oxide with the temperature. When the open circuit potential-charged capacity plot largely changes with the temperature such as when using lithium cobalt oxide, correction is performed in accordance with the plots shown in FIGS. 8A and 8B on an open circuit potential E(T) at the measurement temperature T by using equation (23) below where $T_0$ is the reference temperature:

$$E(T) = E(T_0) - (T - T_0) \times \Delta S \qquad (23)$$

Based on the open circuit potentials Ec(T) and Ea(T) of the cathode and anode at the measurement temperature T of the cell, more accurate parameter values can be calculated by regression calculations with respect to the cell charging curve.

The calculations of Rohm, Rct, and Rd will now be explained. In this explanation, the third method of the methods of calculating Rohm, Rct, and Rd is used.

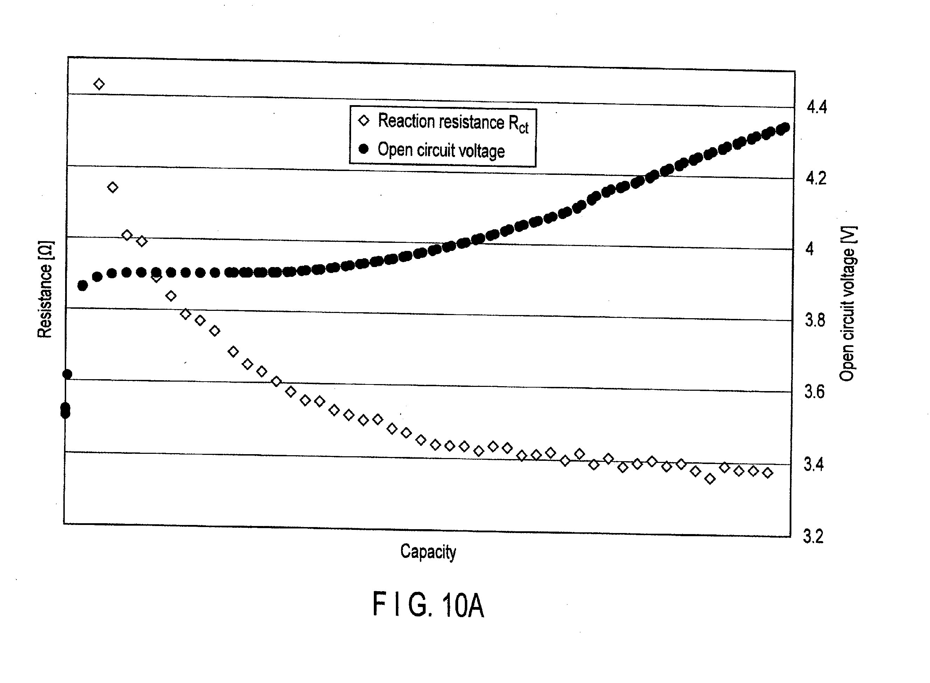

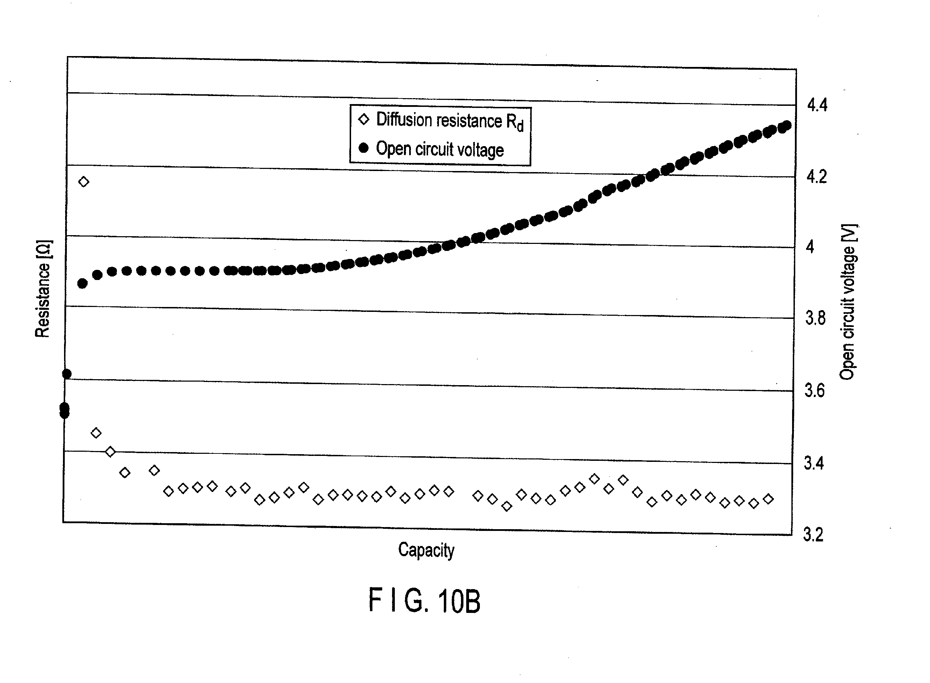

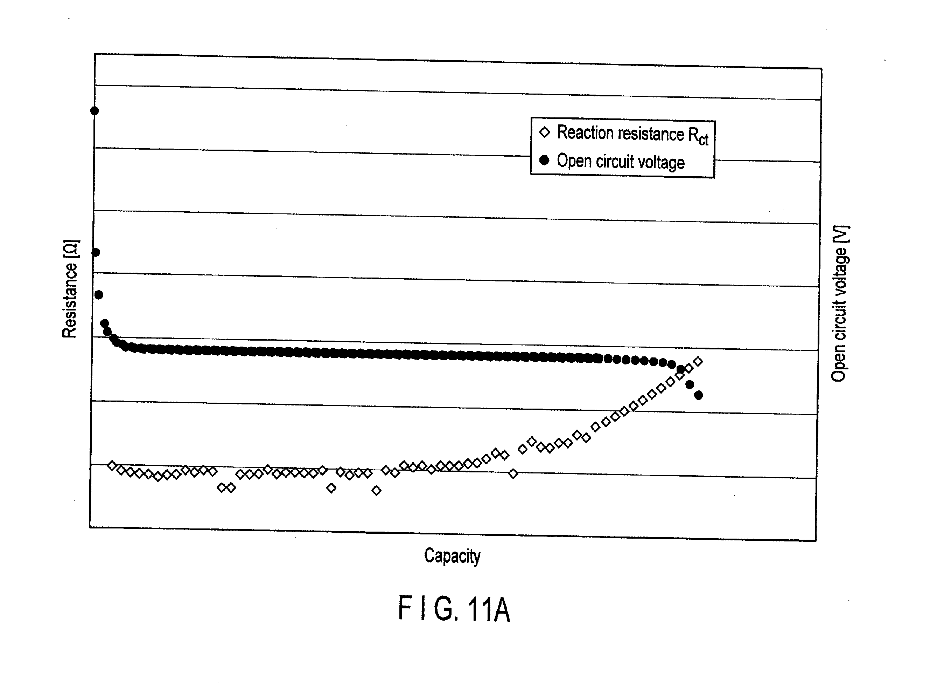

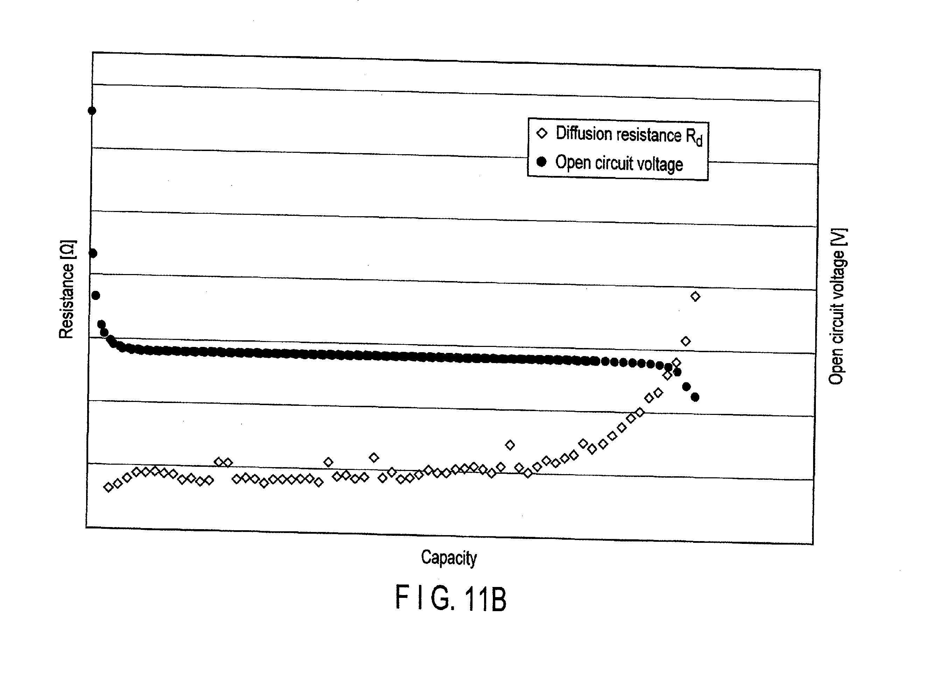

FIGS. 10A and 10B are views in which the reaction resistance component and diffusion resistance component of lithium cobalt oxide are plotted with respect to the charged capacity. FIGS. 11A and 11B are views in which the reaction resistance component and diffusion resistance component of lithium titanate are plotted with respect to the charged capacity. The diffusion resistance changes its behavior in accordance with the charging/discharging direction. The plots shown in FIGS. 10B and 11B indicate the values of the diffusion resistance in the charging direction because the purpose is the analysis of the charging curve.

The change in R(q) with respect to the charged capacity q in:

$$V_c = f_c(q/Q_{ic}) - f_a(q/Q_{ia}, I/Q_{ia}) + R(q) \times I \qquad (11A)$$

includes the dependence of the reaction resistance and diffusion resistance of the active material on the charged capacity shown in FIGS. 10A, 10B, 11A, and 11B. That is, as the ratio occupied by the reaction resistance in the internal resistance increases, the reaction resistance component-charged capacity dependence appears more clearly in the charged capacity change R(q) of the internal resistance as a cell. From this correlation, the ratios of Rct and Rd in the internal resistance of the cell are calculated by regression calculations.

It is possible to calculate Rohm(T) by the internal resistance, Rct(T), and Rd(T) of the cell calculated as described above, and obtain the value of Rohm(T) by the internal resistance value, Rct(T), and Rd(T) at the measurement temperature T of the cell.

(Calculation of Temperature Dependence Constants)

The measurements and calculations of constants to be used in temperature correction will be explained by taking examples.

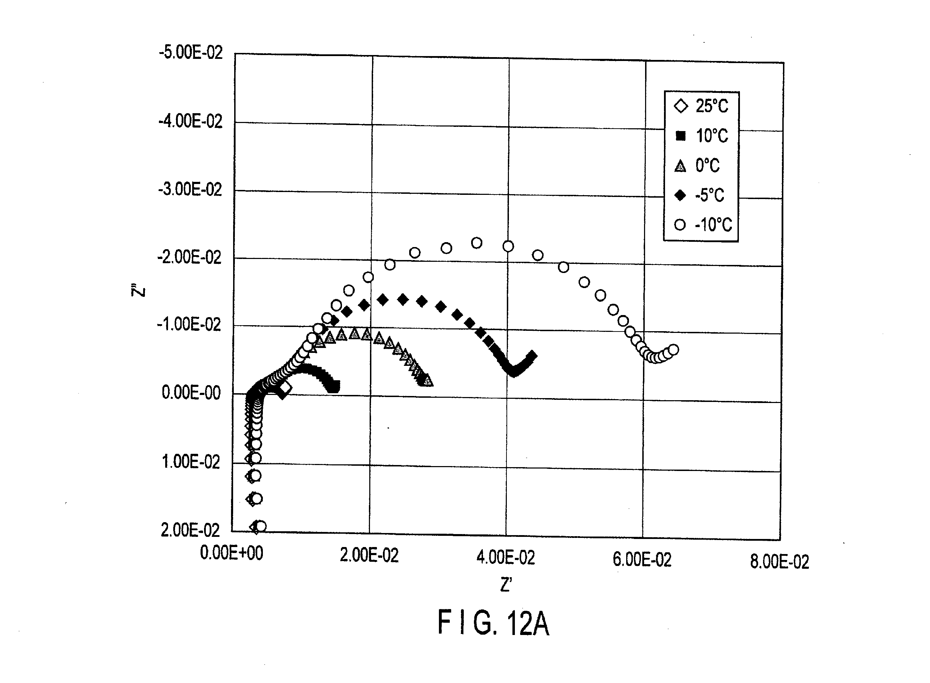

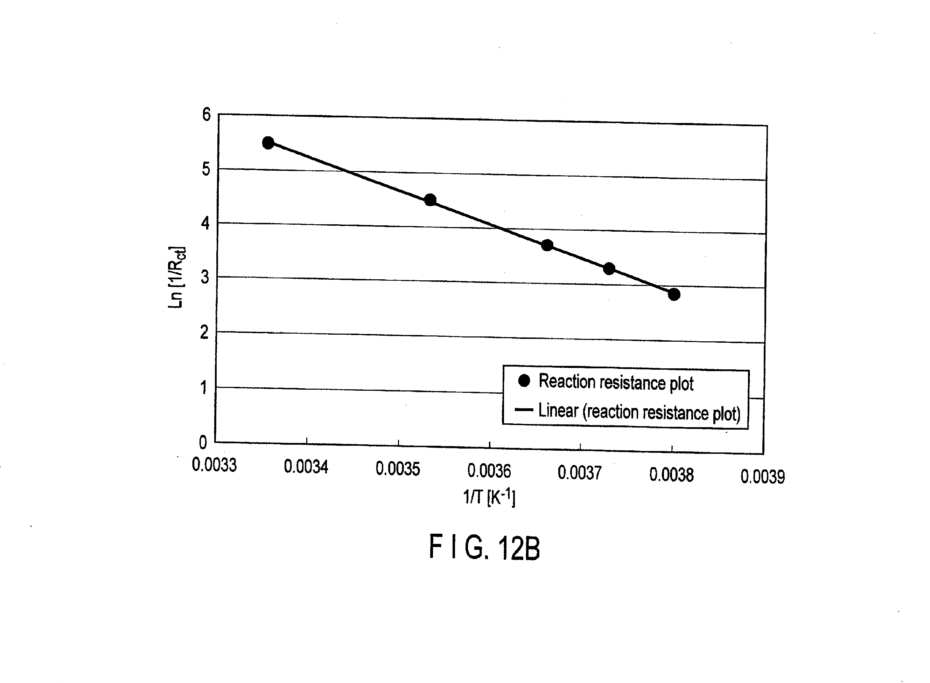

The reaction resistance component and ohmic resistance component can be measured by AC impedance measurement. FIG. 12A shows AC impedance measurement results (Cole-Cole plots) measured for a cell using lithium cobalt oxide as a cathode and lithium titanate as an anode. In these plots shown in FIG. 12A, an arc diameter portion can be regarded as the reaction resistance component, and the value of Z' in an arc starting portion can be regarded as the ohmic resistance component. FIG. 12B shows an Arrhenius plot of the reaction resistance component.

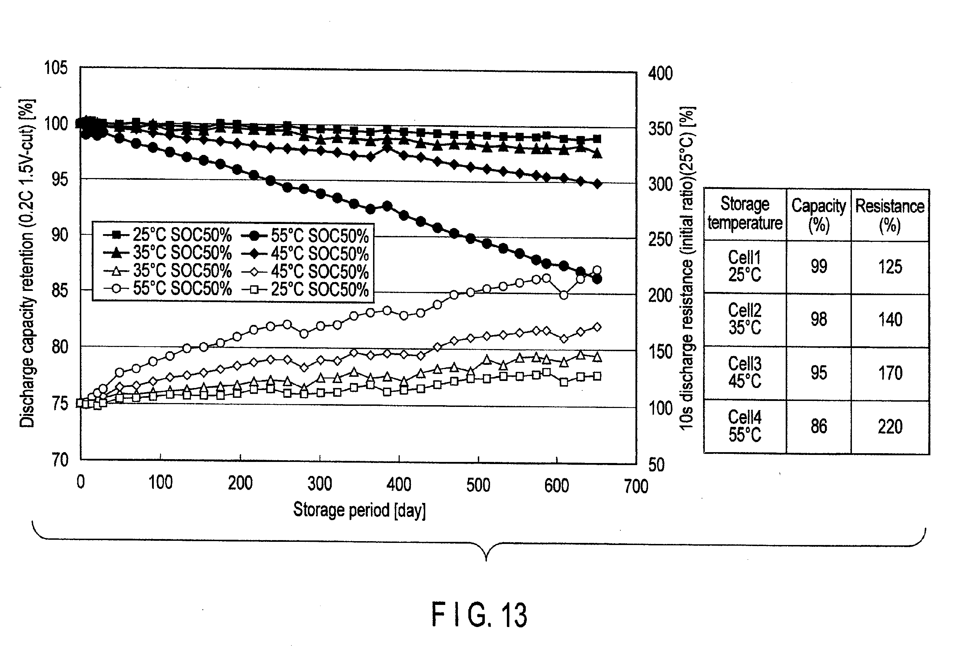

FIG. 13 shows the results of cell storage tests conducted at different temperatures. After the storage tests were conducted for about 650 days, the deteriorated states were that cell 1 (storage temperature = 25°C) had a capacity of 99% and a resistance of 125%, cell 2 (storage temperature = 35°C) had a capacity of 98% and a resistance of 140%, cell 3 (storage temperature = 45°C) had a capacity of 95% and a resistance of 170%, and cell 4 (storage temperature = 55°C) had a capacity of 86% and a resistance of 220%.

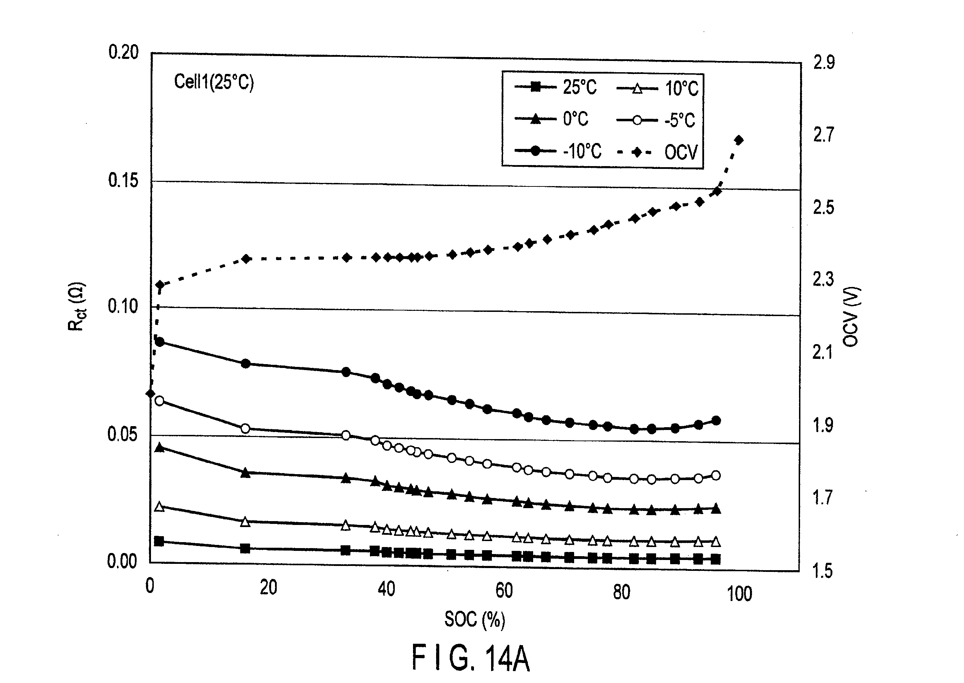

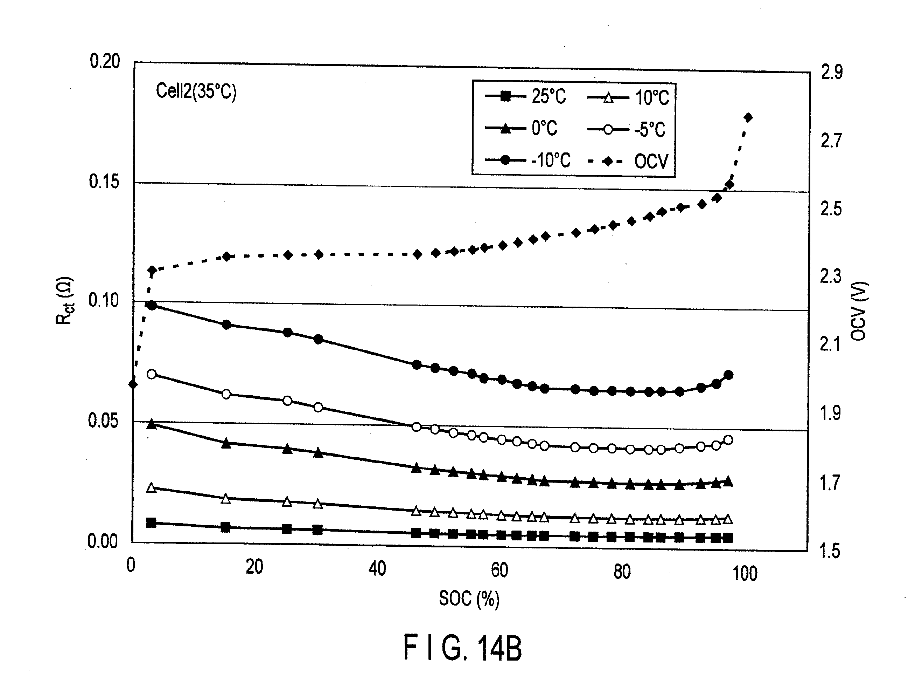

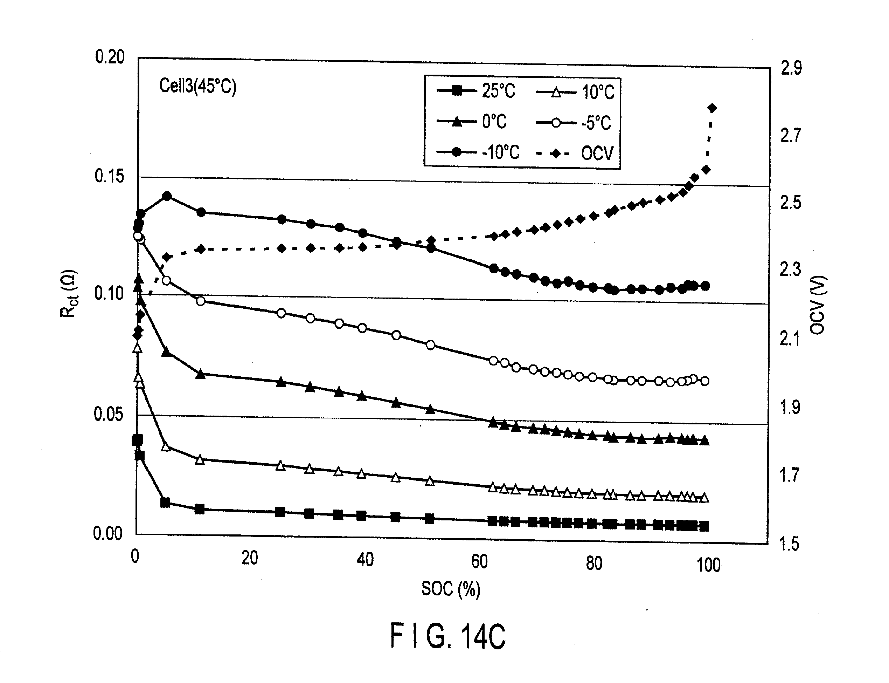

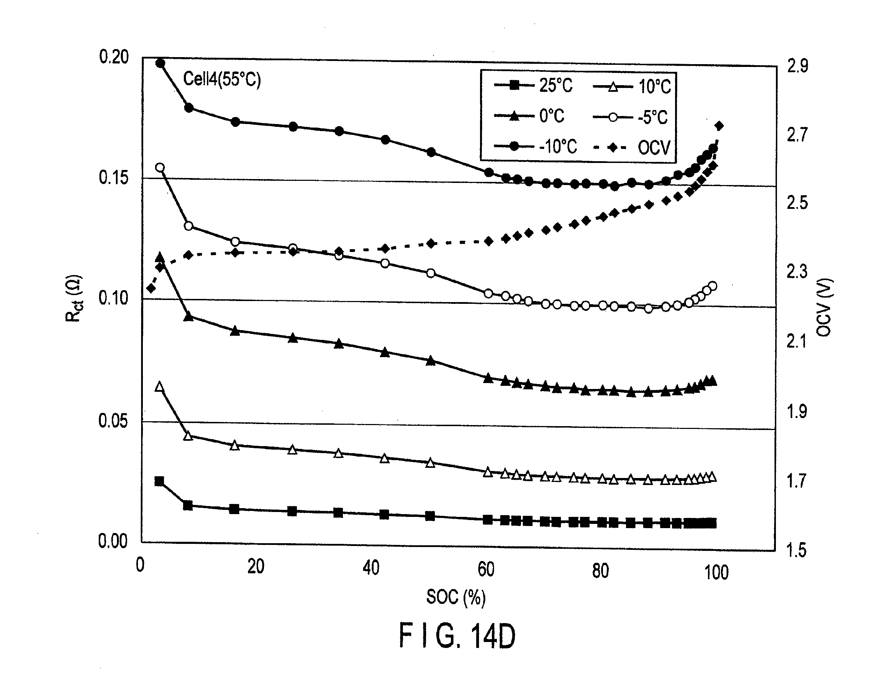

FIGS. 14A, 14B, 14C, and 14D show plots of the reaction resistance component Rct measured with different charged capacities (SOC) at different temperatures for cells (cells 1 to 4) having different deteriorated states after the storage tests shown in FIG. 13. As shown in FIGS. 14A, 14B, 14C, and 14D, the reaction resistance largely deteriorated as deterioration progressed, and the temperature dependence was larger than that of other resistance components (to be described later):

$$\mathrm{Rct(T)} = 1 / \{\mathrm{A} \times \exp(-\mathrm{E_a}/\mathrm{R \cdot T})\} \qquad (24)$$

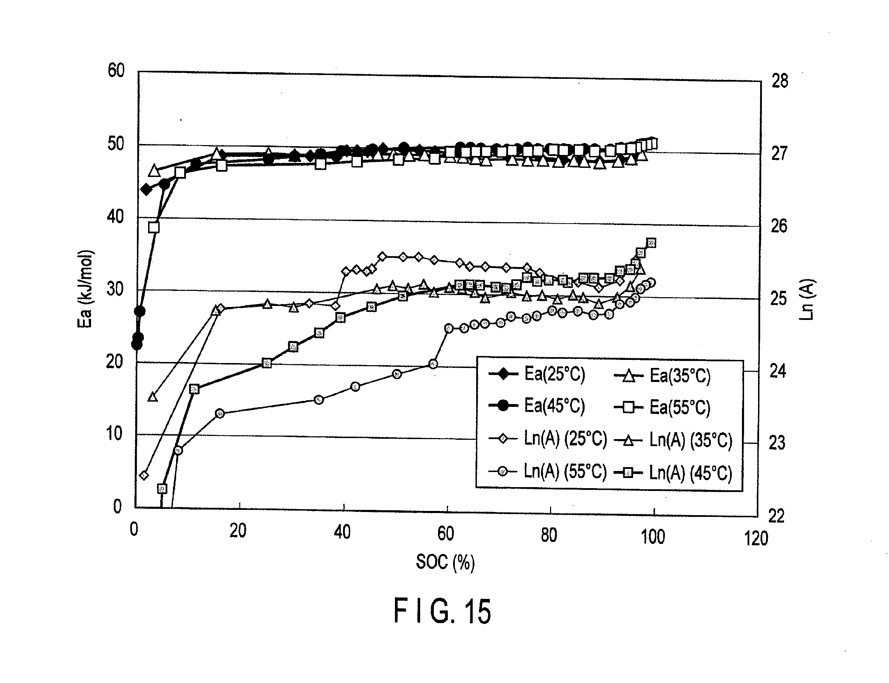

FIG. 15 shows the values of Ea and A calculated in accordance with equation (24) from the measurement values obtained for the SOC values of cells 1 to 4 shown in FIG. 13. As shown in FIG. 15, the value of Ea determining the temperature dependence was calculated, and the value did not change by deterioration.

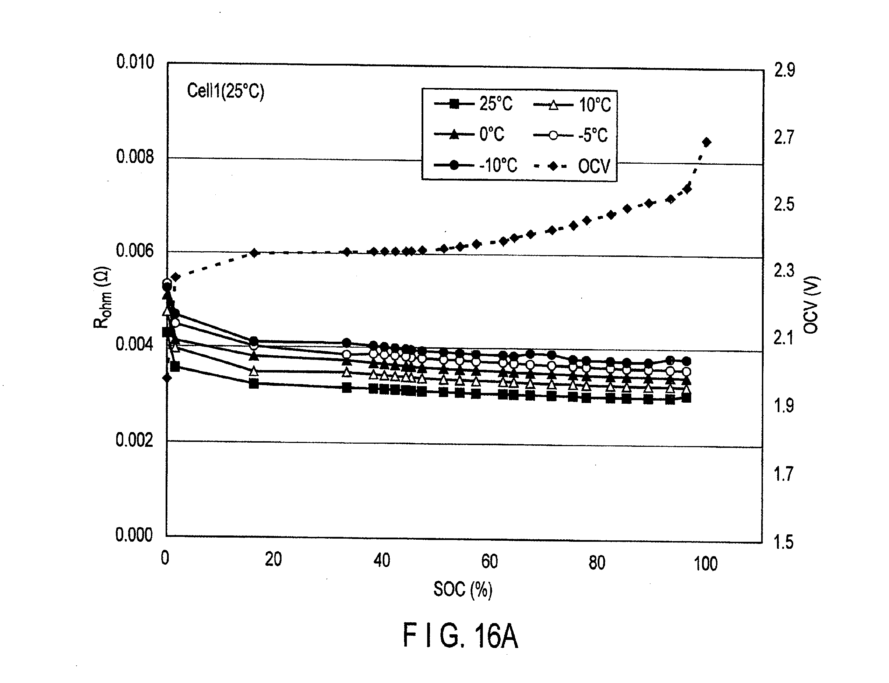

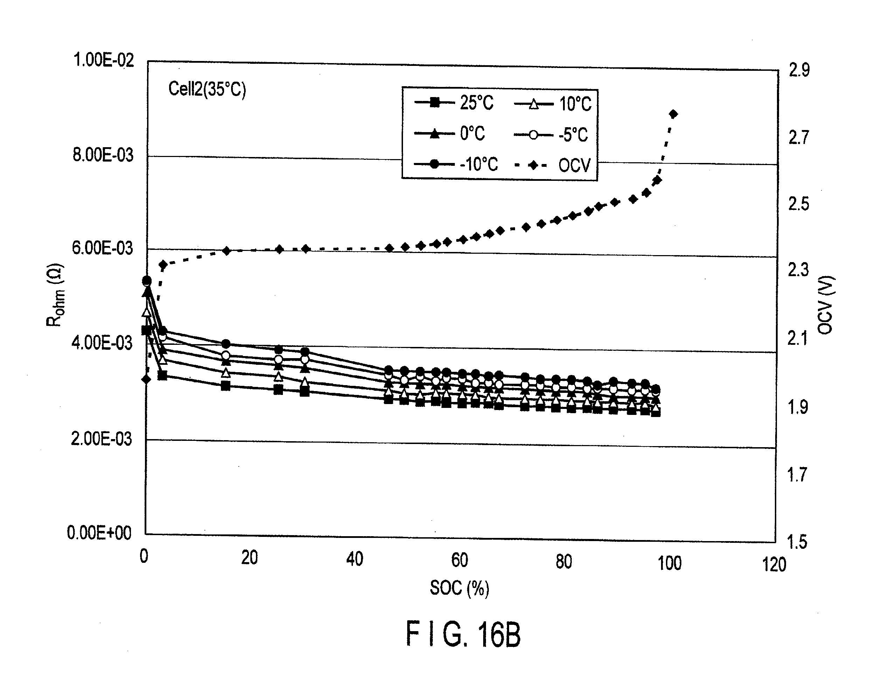

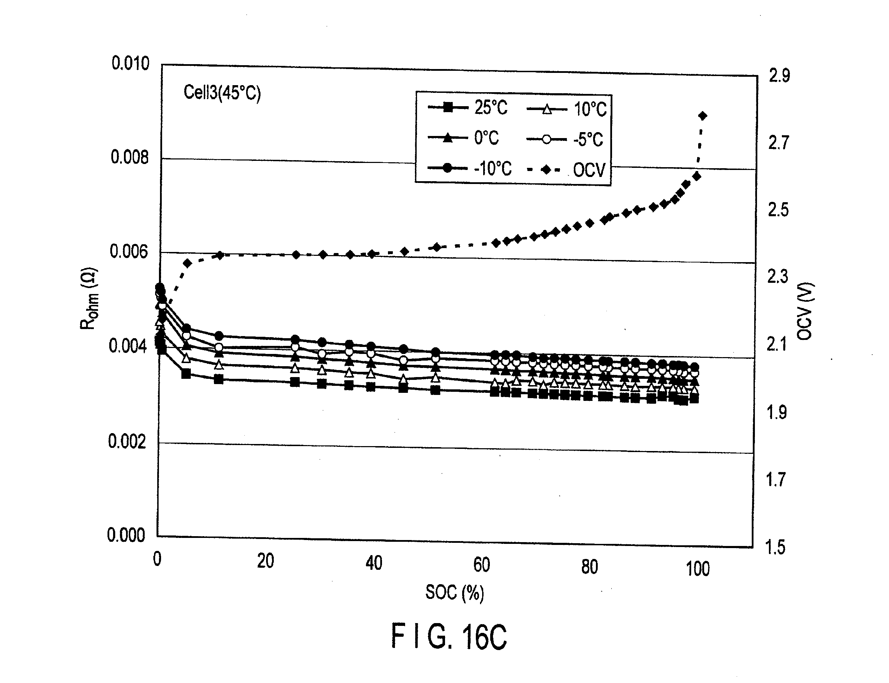

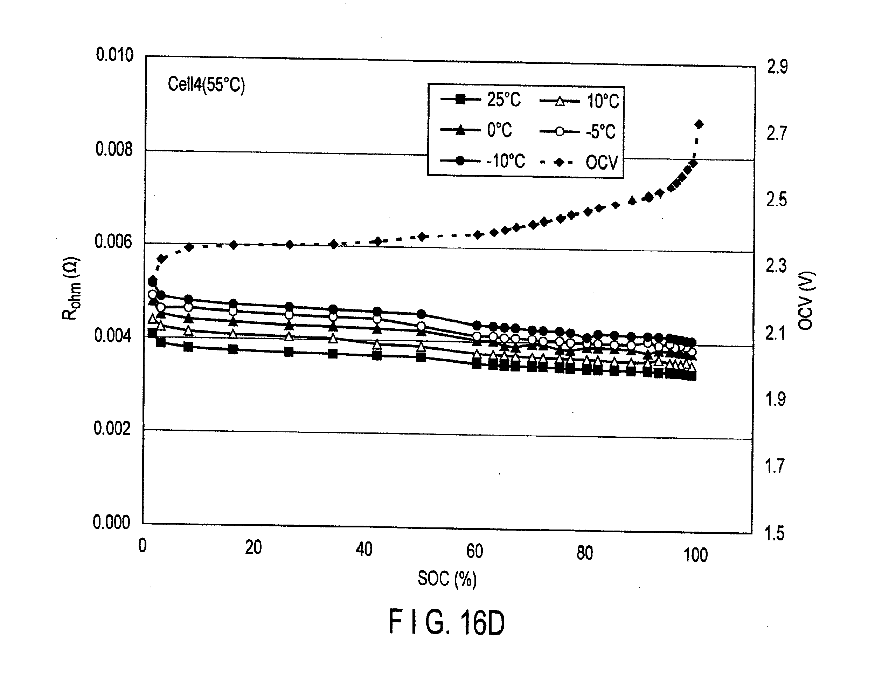

FIGS. 16A, 16B, 16C, and 16D show plots of the ohmic resistance component Rohm measured with different charged capacities (SOC) at different temperatures for cells (cells 1 to 4) having different deteriorated states after the storage tests shown in FIG. 13. As shown in FIGS. 16A, 16B, 16C, and 16D, the ohmic resistance component did not largely increase due to deterioration of the cell, and did not largely change with the temperature either:

$$\mathrm{Rohm(T)} = 1 / \{\mathrm{A} \times \exp(-\mathrm{E_c}/\mathrm{R \cdot T})\} + \mathrm{R1(const.)} \qquad (25)$$

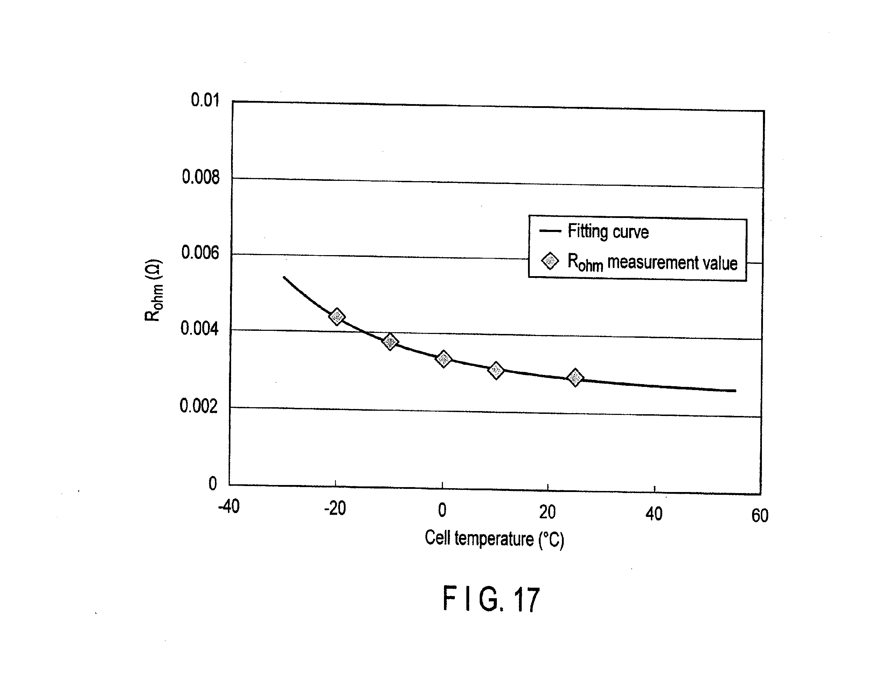

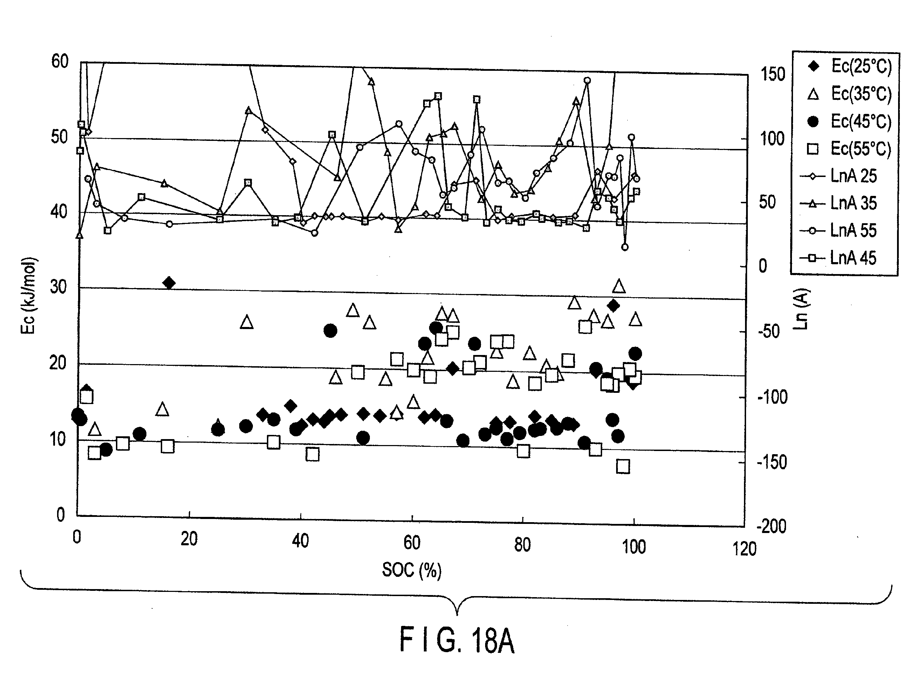

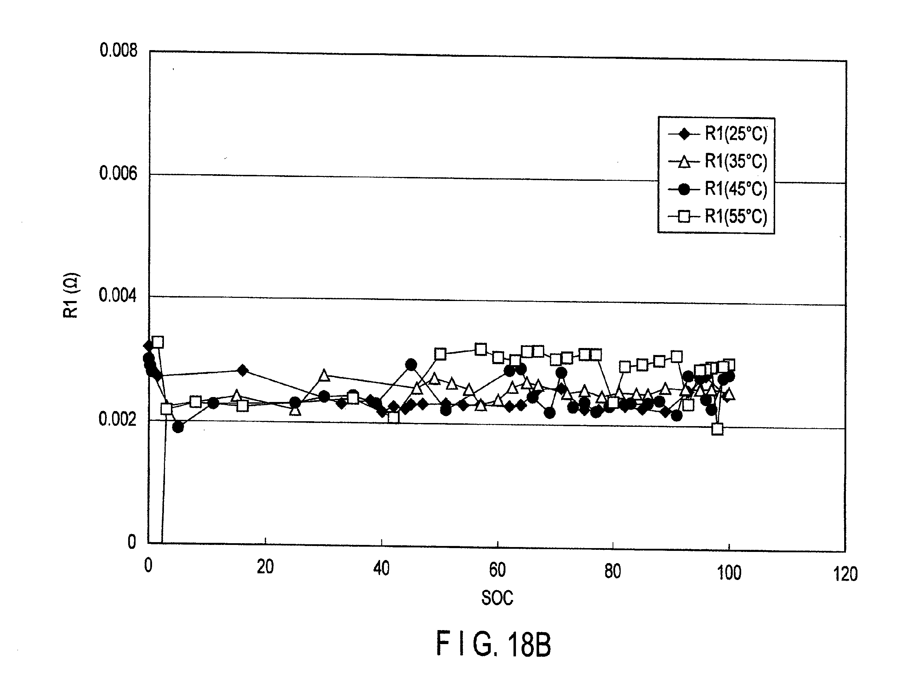

FIG. 17 shows a plot of the ohmic resistance as a function of the cell temperature, and reveals that the relationship of equation (25) is met. Ec, A, and R1 were calculated for cells 1 to 4 by fitting to equation (25). FIG. 18A shows the calculation results of Ec and A. FIG. 18B shows the calculation results of R1.

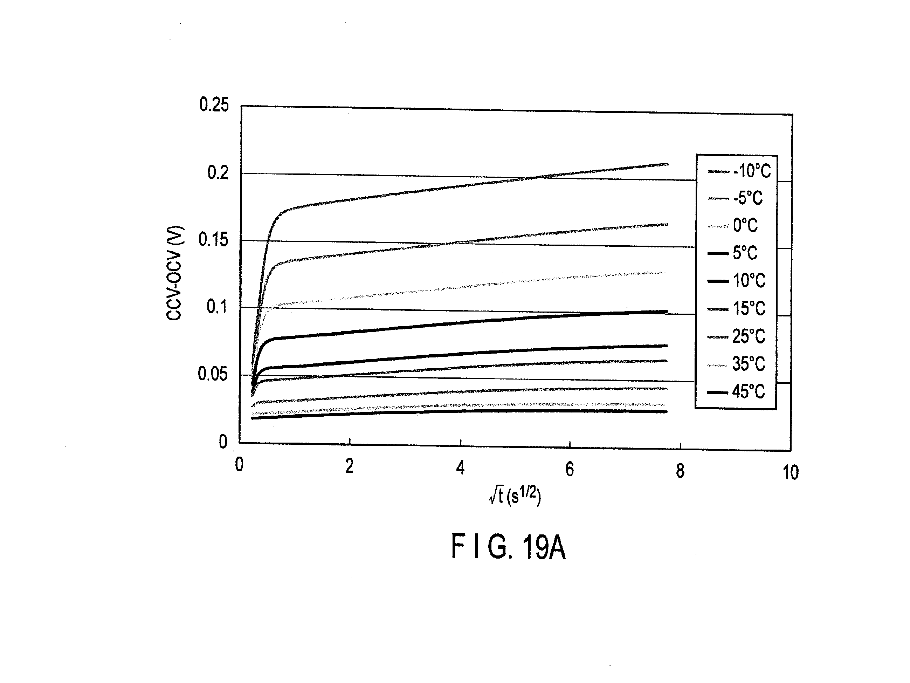

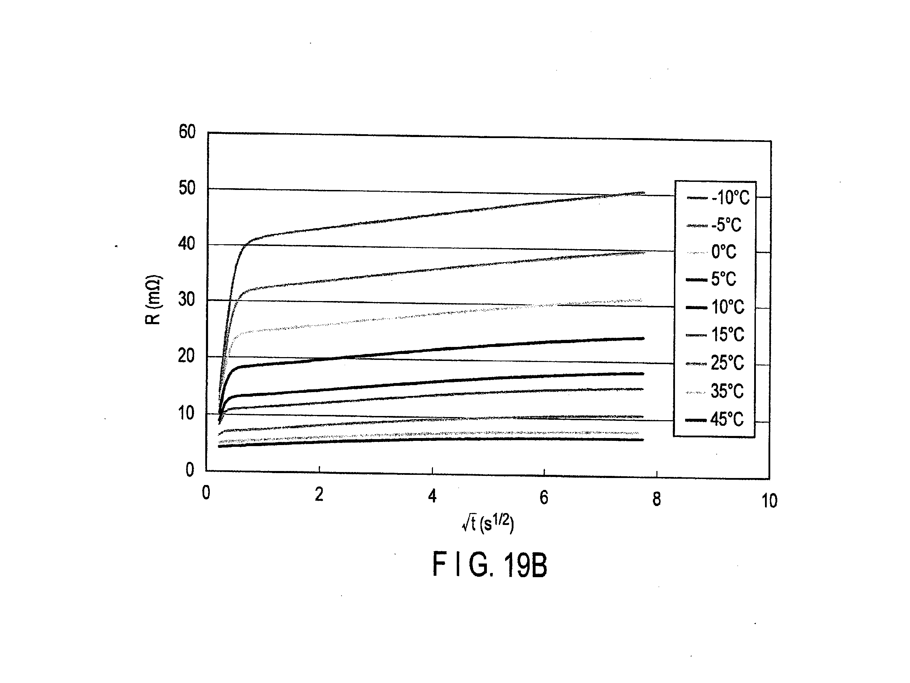

The diffusion resistance component Rd can be measured by, e.g., a constant current pulse method. FIG. 19A shows measurement results when a charging current pulse was applied to a cell using lithium cobalt oxide as a cathode and lithium titanate as an anode. The abscissa indicates the square root of time when the current application start time is 0, and the ordinate indicates a value obtained by subtracting the open circuit voltage (OCV) from the cell voltage (CCV). Referring to FIG. 19A, the intercept is an overvoltage by the ohmic resistance and reaction resistance, the increase is an overvoltage by the diffusion resistance at a predetermined inclination with respect to the square root of time. That is, a value obtained by dividing this overvoltage by the current value is the internal resistance value (FIG. 19B). Referring to FIG. 19B, the intercept of R is the sum of the reaction resistance and ohmic resistance, and the increase proportional to $t^{1/2}$ is the diffusion resistance.

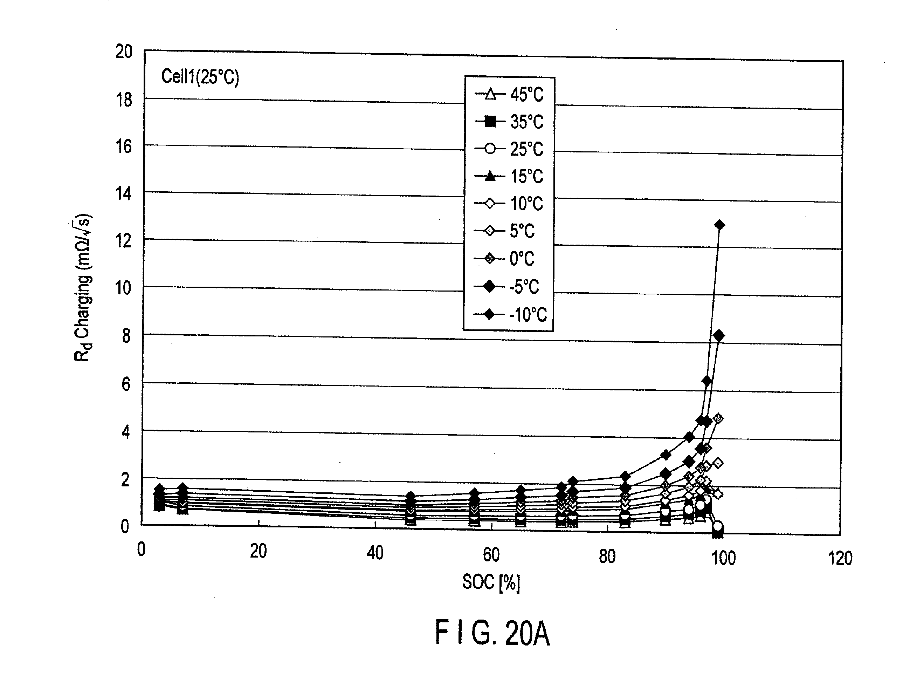

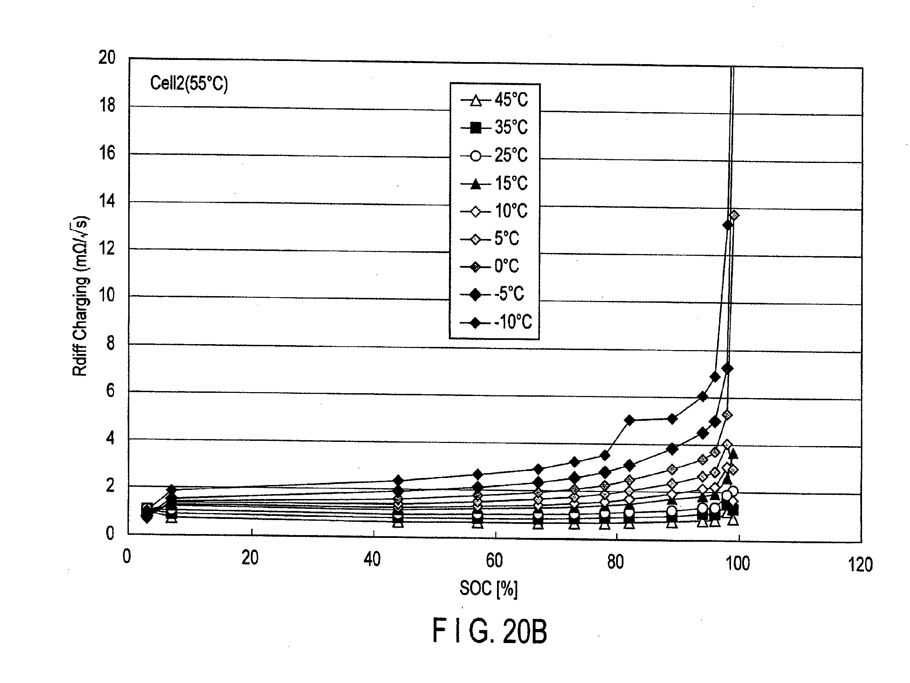

FIGS. 20A and 20B show results when the diffusion resistances of two cells (storage temperatures = 25°C and 55°C) having different deterioration degrees were measured by changing the SOC and temperature:

$$\mathrm{Rd(T)} = 1 / \{\mathrm{A} \times \exp(-\mathrm{E_b}/\mathrm{R \cdot T})\} \qquad (26)$$

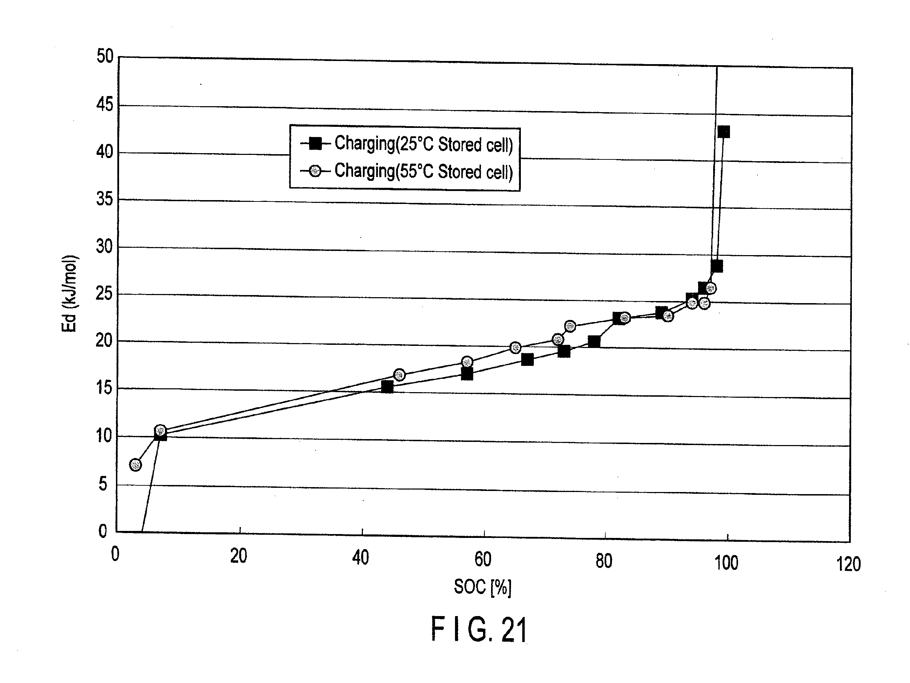

FIG. 21 shows results when Eb was obtained for cells 1 and 2 in accordance with equation (26). FIG. 21 reveals that Eb did not significantly change due to deterioration.

In the method described above, the temperature dependence constants Ea, Eb, and Ec of each resistance component can be calculated. It was also confirmed that the principle of the temperature correction method of this embodiment was effective for a deteriorated cell in which Ea, Eb, and Ec dot not change due to deterioration.

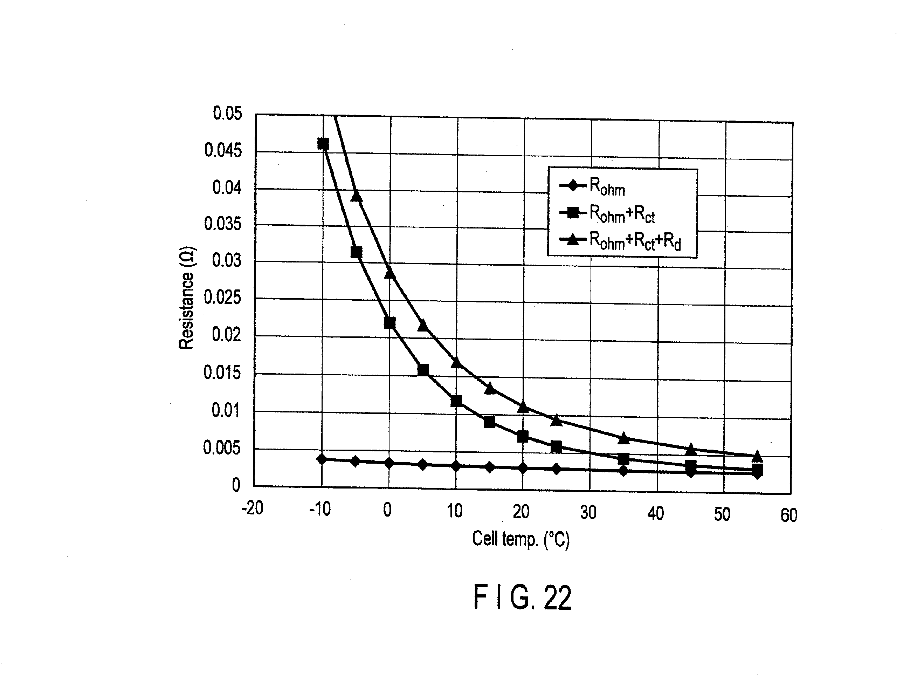

FIG. 22 is a view the change in internal resistance with the temperature in the cell of the embodiment is plotted by using Ea, Eb, and Ec calculated as described above. FIG. 22 shows the ohmic resistance, reaction resistance, and diffusion resistance by integration based on Ea, Eb, Ec, and the results of electrochemical measurements by taking the temperature on the abscissa, and the resistance value on the ordinate. The internal resistance at the reference temperature can be calculated when Ea, Eb, and Ec are already known and the values of Rct, Rd, and Rohm at a given temperature T within the cell usable range are known. FIG. 22 also shows that the change in resistance with the temperature is very large, and the changes in ohmic resistance and diffusion resistance with the temperature are relatively small.

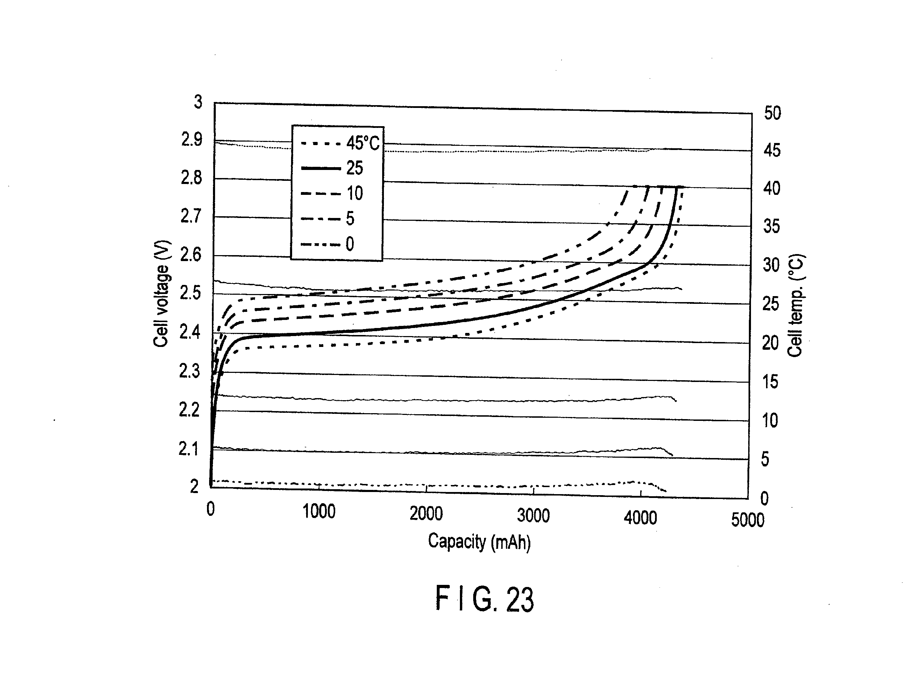

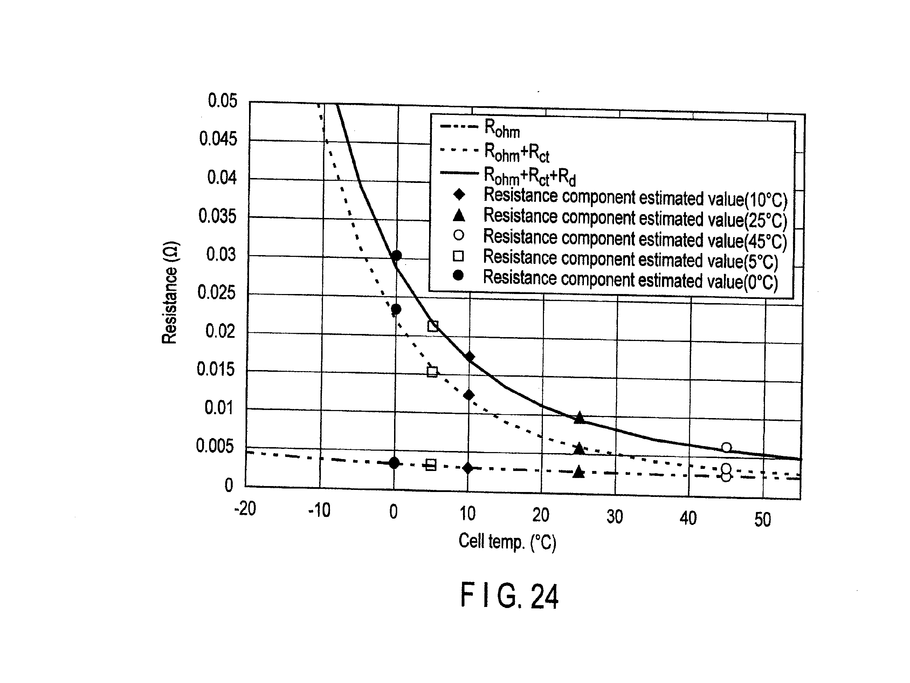

FIG. 23 shows charging curves when cell 1 was charged at 0°C, 5°C, 10°C, 25°C, and 45°C, and plots of the cell surface temperature. FIG. 24 shows results when regression calculation analysis was performed on the charging curves and Rct, Rd, Rohm were calculated for the charging curves at the individual temperatures. The estimated values of the resistance components well match Rct, Rd, and Rohm measured by an electrochemical method and indicated by the solid line, dotted line, and two-dot dashed line, respectively, in FIG. 24.

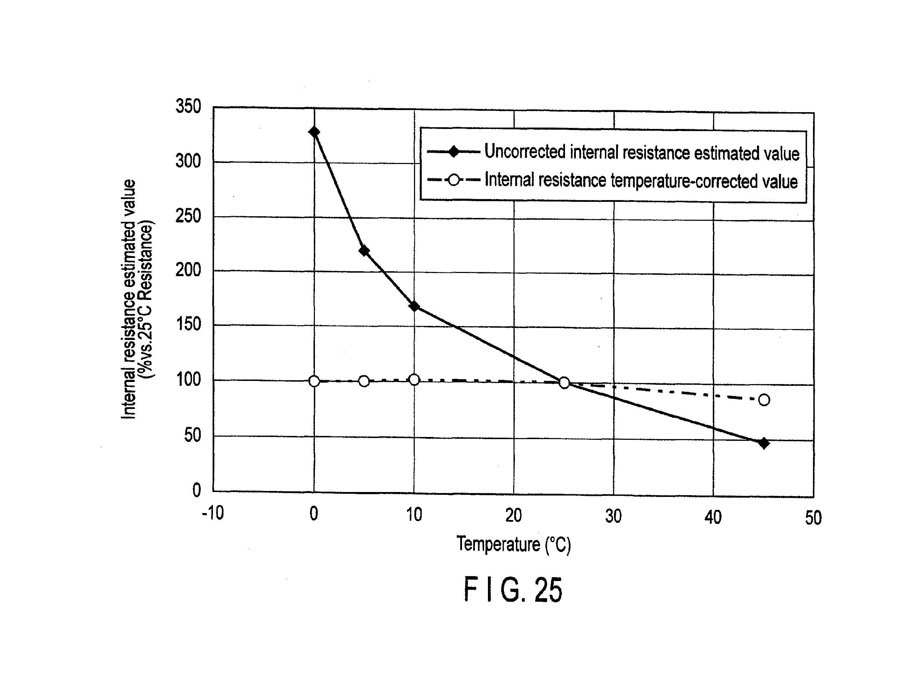

FIG. 25 shows results when the internal resistance values calculated at the different temperatures based on the above-mentioned results were corrected to the reference temperature (25°C). FIG. 25 plots the internal resistance estimated values before and after the correction by taking the cell temperatures at which the charging curves were measured on the abscissa, and the ratio (%) to the internal resistance value at 25°C on the ordinate. The internal resistance value before the correction was large at low temperatures and small at high temperatures due to the influence of the temperature. When this internal resistance value was corrected by the method of this embodiment, it was possible to perform temperature correction to a value almost equal to the resistance value at the reference temperature (25°C).

That is, when performing a cell performance estimation method of calculating the cell characteristics including the cell capacity and internal resistance value by performing cell state calculations by using the temperature, current, and voltage data measured at an arbitrary temperature while the cell is charged or discharged, and using the previously held open circuit voltage-charged capacity of the cathode active material and anode active material, it is possible to correct the estimated value of the internal resistance in accordance with the temperature, and evaluate the increase in internal resistance caused by deterioration.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the inventions. The accompanying claims and their equivalents are intended to cover such forms or modifications as would fall within the scope of the inventions.

**Claims**

1. A secondary battery cell performance estimation method comprising:

    storing data obtained by measuring a secondary cell temperature, an electric current, and a voltage while the secondary cell is charged or discharged;

    estimating an internal resistance value of the secondary cell from a charging/discharging curve by using the secondary cell temperature data, the electric current data, and the voltage data, and predetermined data indicating a relationship between a charged capacity and open circuit voltages of a cathode active material and anode active material;

    calculating a reaction resistance component, an ohmic resistance component, and a diffusion resistance component by dividing the estimated internal resistance value into three components; and

    correcting the estimated internal resistance value based on a value obtained by correcting the reaction resistance component using a coefficient Ea in accordance with a temperature, correcting the ohmic resistance component using a coefficient Eb in accordance with the temperature, and the diffusion resistance component using a coefficient Ec in accordance with the temperature, and adding up the corrected components, wherein the coefficient Ea is a constant for determining a dependence of the reaction resistance component on the temperature, the coefficient Eb is a constant for determining a dependence of the ohmic resistance component on the temperature, and the coefficient Ec is a constant for determining a dependence of the diffusion resistance component on the temperature.

2. The method according to claim 1, wherein in the estimating, the data indicating the relationship between the charged capacity and the open circuit voltages of the cathode active material and anode active material is corrected in accordance with a temperature based on data indicating a relationship between an entropy value of each active material and the charged capacity, with respect to a cell temperature at which the data indicating the relationship between the charged capacity and the open circuit voltages of the cathode active material and anode active material is measured.

3. The method according to claim 1, wherein in the correcting, when using the coefficients Ea, Eb, Ec, and R1 to be used in the temperature correction of the secondary cell and a secondary cell temperature T, temperature correction of a reaction resistance component Rct, a diffusion resistance component Rd, and an ohmic resistance component Rohm is performed at a reference temperature To as follows:

$$Rct(T_0) = Rct(T) \times Exp(-Ea/(R \cdot T))/Exp(-Ea/(R \cdot T_0))$$

$$Rd(T_0) = Rd(T) \times Exp(-Eb/(R \cdot T))/Exp(-Eb/(R \cdot T_0))$$

$$Rohm(T_0) = (Rohm(T) - R1) \times Exp(-Ec/(R \cdot T))/Exp(-Ec/(R \cdot T_0)) + R1$$

4. The method according to claim 1, wherein in the calculating, the reaction resistance component, the ohmic resistance component, and the diffusion resistance component are calculated by a regression calculation by using predetermined data indicating a relationship between the charged capacity and the diffusion resistance of each active material, predetermined data indicating a relationship between the charged capacity and the reaction resistance of each active material, and predetermined data indicating a relationship between the charged capacity and the ohmic resistance of each active material.

5. The method according to claim 1, wherein in the calculating, the reaction resistance component and the diffusion resistance component are calculated by using predetermined data indicating a relationship between the charged capacity and the reaction resistance of each active material, and predetermined data indicating a relationship between the charged capacity and the diffusion resistance of each active material, and a residual between the reaction resistance component and the diffusion resistance component is used as the ohmic resistance component.

6. The method according to claim 1, wherein in the calculating, the ohmic resistance component and the diffusion resistance component are held constant, and a residual between the estimated internal resistance value and a sum of the ohmic resistance component and the diffusion resistance component is used as the reaction resistance component.

7. The method according to claim 1, wherein in the calculating, the ohmic resistance component and the diffusion resistance component are estimated by a function of an accumulated time or an accumulated power amount, and a residual between the estimated internal resistance value and a sum of the ohmic resistance component and the diffusion resistance component is used as the reaction resistance component.

8. A secondary battery cell performance estimation apparatus comprising:

a storage unit (160) configured to store data obtained by measuring a secondary cell temperature, an electric current, and a voltage while the secondary cell is charged or discharged;
an estimation unit (151) configured to estimate an internal resistance value of the secondary cell from a charging/discharging curve by using the secondary cell temperature data, the electric current data, and the voltage data, and predetermined data indicating a relationship between a charged capacity and open circuit voltages of a cathode active material and anode active material;
a calculation unit (151) configured to calculate a reaction resistance component, an ohmic resistance component, and a diffusion resistance component by dividing the estimated internal resistance value into three components; and

a correction unit (151) configured to correct the estimated internal resistance value based on a value obtained by correcting the reaction resistance comment using a coefficient Ea in accordance with a temperature, correcting the ohmic resistance component using a coefficient Eb in accordance with the temperature, correcting the diffusion resistance component using a coefficient Ec in accordance with the temperature, and adding up the corrected components, wherein the coefficient Ea is a constant for determining a dependence of the reaction resistance component on the temperature, the coefficient Eb is a constant for determining a dependence of the ohmic resistance component on the temperature, and the coefficient Ec is a constant for determining a dependence of the diffusion resistance component on the temperature.

9. The apparatus according to claim 8, wherein the estimation unit is configured to correct the data indicating the relationship between the charged capacity and the open circuit voltages of the cathode active material and anode active material in accordance with a temperature based on data indicating a relationship between an entropy value of each active material and the charged capacity, with respect to a secondary cell temperature at which the data indicating the relationship between the charged capacity and the open circuit voltages of the cathode active material and anode active material is measured.

10. The apparatus according to claim 8, wherein when using the coefficients Ea, Eb, Ec, and R1 to be used in the temperature correction of the secondary cell and a secondary cell temperature T, the correction unit is configured to perform temperature correction of a reaction resistance component Rct, a diffusion resistance component Rd, and an ohmic resistance component Rhom at a reference temperature To as follows:

$$Rct(T_0) = Rct(T) \times Exp(-Ea/(R \cdot T))/Exp(-Ea/(R \cdot T_0))$$

$$Rd(T_0) = Rd(T) \times Exp(-Eb/(R \cdot T))/Exp(-Eb/(R \cdot T_0))$$

$$Rohm(T_0) = (Rohm(T) - R1) \times Exp(-Ec/(R \cdot T))/Exp(-Ec/(R \cdot T_0)) + R1$$

11. The apparatus according to claim 8, wherein the calculation unit is configured to calculate the reaction resistance component, the ohmic resistance component, and the diffusion resistance component by a regression calculation by using predetermined data indicating a relationship between the charged capacity and the diffusion resistance of each active material, predetermined data indicating a relationship between the charged capacity and the reaction resistance of each active material, and predetermined data indicating a relationship between the charged capacity and the ohmic resistance of each active material.

12. The apparatus according to claim 8, wherein the calculation unit is configured to calculate the reaction resistance component and the diffusion resistance component by using predetermined data indicating a relationship between the charged capacity and the reaction resistance of each active material, and predetermined data indicating a relationship between the charged capacity and the diffusion resistance of each active material, and is configured to use a residual between the reaction resistance component and the diffusion resistance component as the ohmic resistance component.

13. The apparatus according to claim 8, wherein the calculation unit is configured to hold the ohmic reststance component and the diffusion resistance component constant, and is configured to use a residual between the estimated internal resistance value and a sum of the ohmic resistance component and the diffusion resistance component as the reaction resistance component.

14. The apparatus according to claim 8, wherein the calculation unit is configured to estimate the ohmic resistance component and the diffusion resistance component by a function of an accumulated time or an accumulated power amount, and is configured to use a residual between the estimated internal resistance value and a sum of the ohmic resistance component and the diffusion resistance component as the reaction resistance component.

**Patentansprüche**

1.  Ein Sekundärbatterie-Zellenleistungs-Schätzverfahren, umfassend:

    Speichern von Daten, die erhalten werden durch Messen einer Sekundärzellentemperatur, eines elektrischen Stroms und einer Spannung, während die Sekundärzelle geladen oder entladen wird;
    Schätzen eines internen Widerstandswerts der Sekundärzelle aus einer Lade-/Entladungskurve unter Verwendung der Sekundärzellen-Temperaturdaten, der elektrischen Stromdaten und der Spannungsdaten, und vorbestimmter Daten, die eine Beziehung zwischen einer Ladekapazität und Offene-Schaltungs-Spannungen eines Kathoden-aktiven Materials und eines Anoden-aktiven Materials anzeigen;
    Berechnen einer Reaktionswiderstandskomponenten, einer Ohmschen Widerstandskomponente und einer Diffusionswiderstandskomponente durch Dividieren des geschätzten internen Widerstandswerts in drei Komponenten; und
    Korrigieren des geschätzten internen Widerstandswerts auf Grundlage eines Werts, der erhalten wird durch Korrigieren der Reaktionswiderstandskomponente unter Verwendung eines Koeffizienten Ea gemäß einer Temperatur, Korrigieren der Ohmschen Widerstandskomponente unter Verwendung eines Koeffizienten Eb gemäß der Temperatur, und der Diffusionswiderstandskomponente unter Verwendung eines Koeffizienten Ec gemäß der Temperatur, und Aufaddieren der korrigierten Komponenten, wobei der Koeffizient Ea eine Konstante ist zum Bestimmen einer Abhängigkeit der Reaktionswiderstandskomponente von der Temperatur, der Koeffizient Eb eine Konstante ist zum Bestimmen einer Abhängigkeit der Ohmschen Widerstandskomponente von der Temperatur, und der Koeffizient Ec eine Konstante ist zum Bestimmen einer Abhängigkeit der Diffusionswiderstandskomponente von der Temperatur.

2.  Verfahren nach Anspruch 1, wobei bei dem Schätzen die Daten, die die Beziehung zwischen der Ladekapazität und den Offene-Schaltungs-Spannungen des Kathoden-aktiven Materials und Anoden-aktiven Materials anzeigen, gemäß einer Temperatur korrigiert werden, auf Grundlage von Daten, die eine Beziehung zwischen einem Entropiewert von jedem aktiven Material und der Ladekapazität anzeigen, bezüglich einer Zellentemperatur, bei der die Daten, die die Beziehung zwischen der Ladekapazität und den Offene-Schaltungs-Spannungen des Kathoden-aktiven Materials und des Anoden-aktiven Materials anzeigen, gemessen werden.

3.  Verfahren nach Anspruch 1, wobei bei dem Korrigieren, wenn die Koeffizienten Ea, Eb, Ec und R1 verwendet werden, die bei der Temperaturkorrektur der Sekundärzelle und einer Sekundärzellentemperatur T verwendet werden, eine Temperaturkorrektur einer Reaktionswiderstandskomponente Rct, einer Diffusionswiderstandskomponente Rd und einer Ohmschen Widerstandskomponente Rohm bei einer Referenztemperatur $T_0$ wie folgt durchgeführt wird:

    $$Rct(T_0) = Rct(T) \times Exp(-Ea/(R \cdot T))/Exp(-Ea/(R \cdot T_0))$$

    $$Rd(T_0) = Rd(T) \times Exp(-Eb/(R \cdot T))/Exp(-Eb/(R \cdot T_0))$$

    $$Rohm(T_0) = (Rohm(T) - R1) \times Exp(-Ec/(R \cdot T))/Exp(-Ec/(R \cdot T_0)) + R1$$

4.  Verfahren nach Anspruch 1, wobei in der Berechnung die Reaktionswiderstandskomponente, die Ohmsche Widerstandskomponente und die Diffusionswiderstandskomponente durch eine Regressionsberechnung berechnet werden, unter Verwendung von vorbestimmten Daten, die eine Beziehung zwischen der Ladekapazität und dem Diffusionswiderstand von jedem aktiven Material anzeigen, sowie vorbestimmter Daten, die eine Beziehung zwischen der Ladekapazität und dem Reaktionswiderstand von jedem aktiven Material anzeigen, und vorbestimmten Daten, die eine Beziehung zwischen der Ladekapazität und dem Ohmschen Widerstand von jedem aktiven Material anzeigen.

**5.** Verfahren nach Anspruch 1, wobei in dem Berechnen die Reaktionswiderstandskomponente und die Diffusionswiderstandskomponente berechnet werden unter Verwendung von vorbestimmten Daten, die eine Beziehung zwischen der Ladekapazität und dem Reaktionswiderstand von jedem aktiven Material anzeigen, und vorbestimmten Daten, die eine Beziehung zwischen der Ladekapazität und dem Diffusionswiderstand von jedem aktiven Material anzeigen, wobei eine Restgröße zwischen der Reaktionswiderstandskomponente und der Diffusionswiderstandskomponente als die Ohmsche Widerstandskomponente verwendet wird.

**6.** Verfahren nach Anspruch 1, wobei in dem Berechnen die Ohmsche Widerstandskomponente und die Diffusionswiderstandskomponente konstant gehalten werden, und eine Restgröße zwischen dem geschätzten internen Widerstandswert und einer Summe der Ohmschen Widerstandskomponente und der Diffusionswiderstandskomponente als die Reaktionswiderstandskomponente verwendet wird.

**7.** Verfahren nach Anspruch 1, wobei in dem Berechnen die Ohmsche Widerstandskomponente und die Diffusionswiderstandskomponente geschätzt werden durch eine Funktion einer akkumulierten Zeit oder einer akkumulierten Leistungsgröße, und eine Restgröße zwischen dem geschätzten internen Widerstandswert und einer Summe der Ohmschen Widerstandskomponente und der Diffusionswiderstandskomponente verwendet wird als die Reaktionswiderstandskomponente.

**8.** Sekundärbatterie-Zellenleistungs-Schätzvorrichtung, umfassend:

eine Speichereinheit (160), konfiguriert zum Speichern von Daten, die erhalten werden durch Messen einer Sekundärzellentemperatur, eines elektrischen Stroms und einer Spannung, während die Sekundärzelle geladen oder entladen wird;

eine Schätzeinheit (151), konfiguriert zum Schätzen eines internen Widerstandswerts der Sekundärzelle aus einer Lade-/Entladungskurve unter Verwendung der Sekundärzellen-Temperaturdaten der elektrischen Stromdaten und der Spannungsdaten, sowie vorbestimmter Daten, die eine Beziehung zwischen einer Ladekapazität und Offene-Schaltungs-Spannungen eines Kathoden-aktiven Materials und eines Anoden-aktiven Materials anzeigen;

eine Berechnungseinheit (151), konfiguriert zum Berechnen einer Reaktionswiderstandskomponente, einer Ohmschen Widerstandskomponente und einer Diffusionswiderstandskomponente, durch Dividieren des geschätzten internen Widerstandswerts in drei Komponenten; und

eine Korrektureinheit (151), konfiguriert zum Korrigieren des geschätzten internen Widerstandswerts auf Grundlage eines Werts, der erhalten wird durch Korrigieren der Reaktionswiderstandskomponente unter Verwendung eines Koeffizienten Ea gemäß einer Temperatur, Korrigieren der Ohmschen Widerstandskomponente unter Verwendung eines Koeffizienten Eb gemäß der Temperatur, Korrigieren der Diffusionswiderstandskomponente unter Verwendung eines Koeffizienten Ec gemäß der Temperatur, und Aufaddieren der korrigierten Komponenten, wobei der Koeffizient Ea eine Konstante zum Bestimmen einer Abhängigkeit der Reaktionswiderstandskomponente von der Temperatur ist, der Koeffizient Eb eine Konstante zum Bestimmen einer Abhängigkeit der Ohmschen Widerstandskomponente von der Temperatur ist, und der Koeffizient Ec eine Konstante zum Bestimmen einer Abhängigkeit der Diffusionswiderstandskomponente von der Temperatur ist.

**9.** Vorrichtung nach Anspruch 8, wobei die Schätzeinheit konfiguriert ist zum Korrigieren der Daten, die die Beziehung zwischen der Ladekapazität und den Offene-Schaltungs-Spannungen des Kathoden-aktiven Materials und des Anoden-aktiven Materials anzeigen, in Übereinstimmung mit einer Temperatur auf Grundlage von Daten, die eine Beziehung zwischen einem Entropiewert von jedem aktiven Material und der Ladekapazität anzeigt, bezüglich einer Sekundärzellentemperatur, bei der die Daten, die die Beziehung zwischen der Ladekapazität und den Offene-Schaltungs-Spannungen des Kathoden-aktiven Materials und Anoden-aktiven Materials anzeigen, gemessen werden.

**10.** Vorrichtung nach Anspruch 8, wobei bei Verwendung der Koeffizienten Ea, Eb, Ec und R1, die verwendet werden bei der Temperaturkorrektur der Sekundärzelle und einer Sekundärzellentemperatur T, die Korrektureinheit konfiguriert ist zum Durchführen einer Temperaturkorrektur einer Reaktionswiderstandskomponente Rct, einer Diffusionswiderstandskomponente Rd und einer Ohmschen Widerstandskomponente Rohm bei einer Referenztemperatur $T_0$ wie folgt:

$$Rct(T_0) = Rct(T) \times Exp(-Ea/(R \cdot T))/Exp(-Ea/(R \cdot T_0))$$

$$\mathrm{Rd(T_0)=Rd(T)\ \times\ Exp(-Eb/(R\cdot T))/Exp(-Eb/(R\cdot T_0))}$$

$$\mathrm{Rohm(T_0)=(Rohm(T)-R1)\ \times\ Exp(-Ec/(R\cdot T))/Exp(-Ec/(R\cdot}$$

$$\mathrm{T_0))+R1}$$

**11.** Vorrichtung nach Anspruch 8, wobei die Berechnungseinheit konfiguriert ist zum Berechnen der Reaktionswiderstandskomponente, der Ohmschen Widerstandskomponente und der Diffusionswiderstandskomponente durch eine Regressionsberechnung unter Verwendung von vorbestimmten Daten, die eine Beziehung zwischen der Ladekapazität und dem Diffusionswiderstand von jedem aktiven Material anzeigen, sowie vorbestimmter Daten, die eine Beziehung zwischen der Ladekapazität und dem Reaktionswiderstand von jedem aktiven Material anzeigen, und vorbestimmten Daten, die eine Beziehung zwischen der Ladekapazität und dem Ohmschen Widerstand von jedem aktiven Material anzeigen.

**12.** Vorrichtung nach Anspruch 8, wobei die Berechnungseinheit konfiguriert ist zum Berechnen der Reaktionswiderstandskomponente und der Diffusionswiderstandskomponente unter Verwendung vorbestimmter Daten, die eine Beziehung zwischen der Ladekapazität und dem Reaktionswiderstand von jedem aktiven Material anzeigen, und vorbestimmter Daten, die eine Beziehung zwischen der Ladekapazität und dem Diffusionswiderstand von jedem aktiven Material anzeigen, und konfiguriert ist zum Verwenden einer Restgröße zwischen der Reaktionswiderstandskomponente und der Diffusionswiderstandskomponente als die Ohmsche Widerstandskomponente.

**13.** Vorrichtung nach Anspruch 8, wobei die Berechnungseinheit konfiguriert ist zum Halten der Ohmschen Widerstandskomponente und der Diffusionswiderstandskomponente als konstant, und konfiguriert ist zum Verwenden einer Restgröße zwischen dem geschätzten internen Widerstandswert und einer Summe der Ohmschen Widerstandskomponente und der Diffusionswiderstandskomponente als die Reaktionswiderstandskomponente.

**14.** Vorrichtung nach Anspruch 8, wobei die Berechnungseinheit konfiguriert ist zum Schätzen der Ohmschen Widerstandskomponente und der Diffusionswiderstandskomponente durch eine Funktion einer akkumulierten Zeit oder einer akkumulierten Leistungsgröße, und konfiguriert ist zum Verwenden der Restgröße zwischen dem geschätzten internen Widerstandswert und einer Summe der Ohmschen Widerstandskomponente und der Diffusionswiderstandskomponente als die Reaktionswiderstandskomponente.

**Revendications**

**1.** Procédé d'estimation de performance d'un élément de batterie secondaire comprenant :

la mémorisation de données obtenues en mesurant la température, le courant électrique et la tension d'un élément secondaire pendant que l'élément secondaire est chargé ou déchargé ;
l'estimation de la valeur de la résistance interne de l'élément secondaire d'après la courbe de charge/décharge en utilisant les données de température, les données de courant électrique et les données de tension de l'élément secondaire, et des données prédéterminées indiquant la relation entre la capacité chargée et les tensions en circuit ouvert d'un matériau actif de cathode et d'un matériau actif d'anode ;
le calcul de la composante de résistance de réaction, de la composante de résistance ohmique et de la composante de résistance de diffusion en divisant la valeur de la résistance interne estimée en trois composantes ; et
la correction de la valeur de la résistance interne estimée en se basant sur une valeur obtenue en corrigeant la composante de résistance de réaction en utilisant un coefficient Ea selon la température, la correction de la composante de résistance ohmique en utilisant un coefficient Eb selon la température et de la composante de résistance de diffusion en utilisant un coefficient Ec selon la température, et l'addition des composantes corrigées, dans lequel le coefficient Ea est une constante pour déterminer la dépendance de la composante de résistance de réaction par rapport à la température, le coefficient Eb est une constante pour déterminer la dépendance de la composante de résistance ohmique par rapport à la température et le coefficient Ec est une constante pour déterminer la dépendance de la composante de résistance de diffusion par rapport à la température.

**2.** Procédé selon la revendication 1, dans lequel, lors de l'estimation, les données indiquant la relation entre la capacité chargée et les tensions en circuit ouvert du matériau actif de cathode et du matériau actif d'anode sont corrigées selon la température en se basant sur les données indiquant la relation entre la valeur d'entropie de chaque matériau actif et la capacité chargée, par rapport à la température d'un élément à laquelle les données indiquant la relation entre la capacité chargée et les tensions en circuit ouvert du matériau actif de cathode et le matériau actif d'anode est mesurée.

**3.** Procédé selon la revendication 1, dans lequel, lors de la correction, lorsqu'on utilise les coefficients Ea, Eb et Ec, et R1 destinés à être utilisés pour la correction de température de l'élément secondaire et la température T de l'élément secondaire, la correction de température de la composante de résistance de réaction Rct, la composante de résistance de diffusion Rd et la composante de résistance ohmique Rohm est effectuée à une température de référence $T_0$ comme suit :

$$Rct(T_0) = Rct(T) \times Exp(-Ea/(R.T))/Exp(-Ea/(R.T_0))$$

$$Rd(T_0) = Rd(T) \times Exp(-Eb/(R.T))/Exp(-Eb/(R.T_0))$$

$$Rohm(T_0) = (Rohm(T) - R1) \times Exp(-Ec/(R.T))/Exp(-Ec/(R.T_0)) + R1.$$

**4.** Procédé selon la revendication 1, dans lequel, lors du calcul, la composante de résistance de réaction, la composante de résistance ohmique et la composante de résistance de diffusion sont calculées par un calcul de régression en utilisant des données prédéterminées indiquant la relation entre la capacité chargée et la résistance de diffusion de chaque matériau actif, des données prédéterminées indiquant la relation entre la capacité chargée et la résistance de réaction de chaque matériau actif et des données prédéterminées indiquant la relation entre la capacité chargée et la résistance ohmique de chaque matériau actif.

**5.** Procédé selon la revendication 1, dans lequel, lors du calcul, la composante de résistance de réaction et la composante de résistance de diffusion sont calculées en utilisant des données prédéterminées indiquant la relation entre la capacité chargée et la résistance de réaction de chaque matériau actif, et des données prédéterminées indiquant la relation entre la capacité chargée et la résistance de diffusion de chaque matériau actif, et le résidu entre la composante de résistance de réaction et la composante de résistance de diffusion est utilisé en tant que composante de résistance ohmique.

**6.** Procédé selon la revendication 1, dans lequel, lors du calcul, la composante de résistance ohmique et la composante de résistance de diffusion sont maintenues constantes, et le résidu entre la valeur de la résistance interne estimée et la somme de la composante de résistance ohmique et de la composante de résistance de diffusion est utilisé en tant que composante de résistance de réaction.

**7.** Procédé selon la revendication 1, dans lequel, lors du calcul, la composante de résistance ohmique et la composante de résistance de diffusion sont estimées par une fonction du temps accumulé ou d'une quantité de puissance accumulée et le résidu entre la valeur de la résistance interne estimée et la somme de la composante de résistance ohmique et de la composante de résistance de diffusion est utilisé en tant que composante de résistance de réaction.

**8.** Dispositif d'estimation de performance d'un élément de batterie secondaire comprenant :

une unité de mémorisation (160) configurée pour mémoriser des données obtenues en mesurant la température, le courant électrique et la tension d'un élément secondaire pendant que l'élément secondaire est chargé ou déchargé ;
une unité d'estimation (151) configurée pour estimer la valeur de la résistance interne de l'élément secondaire d'après la courbe de charge/décharge en utilisant les données de température, les données de courant électrique et les données de tension de l'élément secondaire, et des données prédéterminées indiquant la relation entre la capacité chargée et les tensions en circuit ouvert d'un matériau actif de cathode et d'un matériau actif d'anode ;
une unité de calcul (151) configurée pour calculer la composante de résistance de réaction, une composante de résistance ohmique et une composante de résistance de diffusion en divisant la valeur de la résistance interne estimée en trois composantes ; et

une unité de correction (151) configurée pour corriger la valeur de la résistance interne estimée en se basant sur une valeur obtenue en corrigeant la composante de résistance de réaction en utilisant un coefficient Ea selon la température, en corrigeant la composante de résistance ohmique en utilisant un coefficient Eb selon la température en corrigeant la composante de résistance de diffusion en utilisant un coefficient Ec selon la température, et en additionnant les composantes corrigées, dans lequel le coefficient Ea est une constante pour déterminer la dépendance de la composante de résistance de réaction par rapport à la température, le coefficient Eb est une constante pour déterminer la dépendance de la composante de résistance ohmique par rapport à la température et le coefficient Ec est une constante pour déterminer la dépendance de la composante de résistance de diffusion par rapport à la température.

9. Dispositif selon la revendication 8, dans lequel l'unité d'estimation est configurée pour corriger les données indiquant la relation entre la capacité chargée et les tensions en circuit ouvert du matériau actif de cathode et du matériau actif d'anode selon la température en se basant sur des données indiquant la relation entre la valeur d'entropie de chaque matériau actif et la capacité chargée, par rapport à la température d'un élément secondaire à laquelle les données indiquant la relation entre la capacité chargée et les tensions en circuit ouvert du matériau actif de cathode et le matériau actif d'anode est mesurée.

10. Dispositif selon la revendication 8, dans lequel, lorsqu'on utilise les coefficients Ea, Eb et Ec, et R1 destinés à être utilisés pour la correction de température de l'élément secondaire et la température T de l'élément secondaire, l'unité de correction est configurée pour effectuer une correction de température de la composante de résistance de réaction Rct, la composante de résistance de diffusion Rd et la composante de résistance ohmique Rohm à une température de référence $T_0$ comme suit :

$$Rct(T_0) = Rct(T) \times Exp(-Ea/(R.T))/Exp(-Ea/(R.T_0))$$

$$Rd(T_0) = Rd(T) \times Exp(-Eb/(R.T))/Exp(-Eb/(R.T_0))$$

$$Rohm(T_0) = (Rohm(T)-R1) \times Exp(-Ec/(R.T))/Exp(-Ec/(R.T_0))+R1.$$

11. Dispositif selon la revendication 8, dans lequel l'unité de calcul est configurée pour calculer la composante de résistance de réaction, la composante de résistance ohmique et la composante de résistance de diffusion par un calcul de régression en utilisant des données prédéterminées indiquant la relation entre la capacité chargée et la résistance de diffusion de chaque matériau actif, des données prédéterminées indiquant la relation entre la capacité chargée et la résistance de réaction de chaque matériau actif et des données prédéterminées indiquant la relation entre la capacité chargée et la résistance ohmique de chaque matériau actif.

12. Dispositif selon la revendication 8, dans lequel l'unité de calcul est configurée pour calculer la composante de résistance de réaction et la composante de résistance de diffusion en utilisant des données prédéterminées indiquant la relation entre la capacité chargée et la résistance de réaction de chaque matériau actif, et des données prédéterminées indiquant la relation entre la capacité chargée et la résistance de diffusion de chaque matériau actif, et est configurée pour utiliser le résidu entre la composante de résistance de réaction et la composante de résistance de diffusion en tant que composante de résistance ohmique.

13. Dispositif selon la revendication 8, dans lequel l'unité de calcul est configurée pour maintenir constantes la composante de résistance ohmique et la composante de résistance de diffusion, et est configurée pour utiliser le résidu entre la valeur de la résistance interne estimée et la somme de la composante de résistance ohmique et de la composante de résistance de diffusion en tant que composante de résistance de réaction.

14. Dispositif selon la revendication 8, dans lequel l'unité de calcul est configurée pour estimer la composante de résistance ohmique et la composante de résistance de diffusion par une fonction du temps accumulé ou d'une quantité de puissance accumulée et est configurée pour utiliser le résidu entre la valeur de la résistance interne estimée et la somme de la composante de résistance ohmique et de la composante de résistance de diffusion en tant que composante de résistance de réaction.

Ohmic resistance

Resistance of ionic conduction of Li in electrolyte

Reaction resistance

Charge transfer resistance
Film resistance

Diffusion resistance

Electrode potential

Electrical resistance of electrode/collector/tab

$Li^+$

Electrolyte

Ionic conductive resistance

$R_{ohm}$

Charge transfer resistance

$R_{ct}$

$R_d$

Lithium diffusion resistance

$e^-$

$R_{ohm}$

FIG. 1

EP 2 762 908 B1

F I G. 2

F I G. 3

F I G. 4

F I G. 5

F I G. 6

F I G. 7A

EP 2 762 908 B1

F I G. 7B

F I G. 8A

EP 2 762 908 B1

F I G. 8B

F I G. 9

F I G. 10A

F I G. 10B

EP 2 762 908 B1

F I G. 11A

F I G. 11B

EP 2 762 908 B1

F I G. 12A

Legend: 25°C, 10°C, 0°C, -5°C, -10°C

Axis: Z', Z''

F I G. 12B

F I G. 13

F I G. 14A

FIG. 14B

F I G. 14C

F I G. 14D

F I G. 15

F I G. 16A

EP 2 762 908 B1

F I G. 16B

EP 2 762 908 B1

F I G. 16C

EP 2 762 908 B1

F I G. 16D

EP 2 762 908 B1

F I G. 17

F I G. 18A

F I G. 18B

F I G. 19A

F I G. 19B

F I G. 20A

F I G. 20B

EP 2 762 908 B1

F I G. 21

F I G. 22

EP 2 762 908 B1

F I G. 23

F I G. 24

EP 2 762 908 B1

F I G. 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2012251806 A
- US 2011309838 A1
- US 2008054848 A1
- US 2009096459 A1
- US 2010141262 A1

### Non-patent literature cited in the description

- **GUERFI A et al.** Investigations on some electrochemical aspects of lithium-ion ionic liquid/gel polymer battery systems. *JOURNAL OF SOLID STATE ELECTROCHEMISTRY ; CURRENT RESEARCH AND DEVELOPMENT IN SCIENCE AND TECHNOLOGY, SPRINGER, BERLIN, DE,* 17 October 2008, vol. 13 (7), 1003-1014
- Kinetic behavior of LiFePO4/C cathode material for lithium-ion batteries. **GAO F et al.** ELECTROCHIMICA ACTA. ELSEVIER SCIENCE PUBLISHERS, 01 June 2008, vol. 53, 5071-5075
- **FURTHER, PRADA E et al.** A coupled OD electrochemical ageing & electro-thermal Li-ion modeling approach for HEV/PHEV. *2011 IEEE VEHICLE POWER AND PROPULSION CONFERENCE (VPPC 2011) : CHICAGO, ILLINOIS, USA,* 06 September 2011, 1-8